# EUROPEAN PATENT APPLICATION

(11) **EP 2 541 607 A2**
(43) Date of publication of application: **02.01.2013**
(21) Application number: 12174158.1
(22) Date of filing: 28.06.2012
(51) Int. Cl.: H01L 29/78, H01L 21/336, H01L 29/10, H01L 29/08, H01L 21/265

(54) **Semiconductor device having a field-effect transistor**

(30) Priority: 29.06.2011 JP 2011144130
(71) Applicant: Hitachi Ltd., Tokyo 100-8280 (JP)
(72) Inventor: Shirakawa, Shinji, Tokyo 100-8220 (JP); Sakano, Junichi, Tokyo 100-8220 (JP)
(74) Representative: MERH-IP Matias Erny Reichl Hoffmann

(57) **Abstract**

An insulated gate field-effect transistor of a semiconductor device, said transistor having a channel region (CH) with a small width (channel length), is disclosed. Specifically, the width (L) of a portion of the channel region planarly overlapped with the gate electrode (G) is larger than or equal to 1/5 times the thickness (t) of the gate electrode and smaller than or equal to said thickness. Thus, variations in the threshold voltage can be reduced. Furthermore, a body region (BD) of the transistor has a lower portion projecting toward a drain region (DR) more than an upper portion of said body region.

## Description

### TECHNICAL FIELD OF THE INVENTION

The present invention relates to a semiconductor device and particularly relates to technique effective in application to a semiconductor device including a field-effect transistor represented by MOSFET (Metal Oxide Semiconductor Field Effect Transistor).

### BACKGROUND OF THE INVENTION

Japanese Patent Application Laid-Open Publication No. H11-266018 describes technique by which the on-state current of a lateral IGBT can be increased. Specifically, an n-type relay layer is formed in a surface of an n⁻-type drift layer so as to be opposed to an n⁺-type source layer. The width of a large-resistance channel region can be reduced by providing this n-type relay layer. The on-state resistance of the lateral IGBT can be reduced as a result; therefore, the on-state current of the lateral IGBT can be increased.

In recent years, large-scale products have been under development by integration of functions and advancement of functions for the integrated circuits in which analog circuits and digital circuits are consolidated. Specifically, for in-car use, industrial use and medical use, development of a large logic-scale product has been carried out by combinations of medium/high-voltage MOSFETs having a breakdown voltage of 20 V to 200 V-class and fine CMOSs (Complementary MOSFETs) capable of constituting a large-scale logic circuit. The fine CMOS is defined as a CMOS in which the gate length of a gate electrode is 350 nm or less. In latest semiconductor processes, for example, integrated circuits (semiconductor device) in which medium-voltage MOSFETs having a withstand voltage of 100 V or less and fine CMOSs having a gate length of 130 nm to 180 nm are consolidated are being manufactured.

In the formation of the above-described fine CMOS, a manufacturing process with small thermal load is essential. Specifically, before gate electrodes are formed, wells of the fine CMOS have to be formed, and thermal diffusion of an impurity to be introduced into the wells has to be suppressed; therefore, after the gate electrodes are formed, the manufacturing process with small thermal load is required. Therefore, in manufacturing steps of a medium/high-voltage MOSFET to be consolidated with the fine CMOS, the steps with large thermal load have to be carried out before the wells of the fine CMOS are formed. Specifically, before formation of the gate electrodes, formation of body regions of the medium/high-voltage MOSFET (step with large thermal load) is carried out; and, after formation of the gate electrodes, only the steps with small thermal load are carried out.

The medium/high-voltage MOSFET consolidated in the integrated circuit is required to have, for example, an important function for outputting analog signals, and, as important performance, the medium/high-voltage MOSFET is required to have a stabilized threshold voltage in order to realize circuit operations of specifications and to have a large output current density in order to reduce an element area.

Regarding this point, in manufacturing steps of a single medium/high-voltage MOSFET for which consolidation with a fine CMOS is not assumed, gate electrodes are used as masks after the gate electrodes are formed aligned with the gate electrodes so as to implant a conductive-type impurity into a semiconductor substrate, and the semiconductor substrate is subjected to high-temperature thermal treatment. Thus, body regions (including channel regions) can be formed by thermally diffusing the implanted conductive-type impurity. The above-described act of using the gate electrodes as masks is to implant the conductive-type impurity from the gate electrodes and an insulating film formed on the gate electrodes with low energy that does not transmit to the semiconductor substrate (silicon). In the above-described step, relative misalignment between source regions and body regions, which are similarly formed by using the gate electrodes as masks, does not occur; therefore, there is an advantage that the channel length and threshold voltage thereof are stably determined. However, this manufacturing step requires application of large thermal load after the gate electrodes are formed; therefore, it is difficult to use this step in manufacturing of an integrated circuit for which consolidation with a fine CMOS is premised.

Therefore, in manufacturing of the integrated circuit for which consolidation with the fine CMOS is premised to be carried out, a step of forming a body region of the medium/high-voltage MOSFET is employed before a gate electrode is formed. However, in this case, the gate electrode cannot be used as a mask; therefore, for example, different masks are respectively used as a mask for forming the body region that determines a threshold voltage and as a mask for forming a source region, and the relative positions of the masks are mutually misaligned. As a result, the length of a channel and the peak density of an impurity that determines the threshold voltage are changed, and the threshold voltage is varied. When the threshold voltage is varied, it becomes difficult to realize circuit operations conforming design specifications. Particularly, variation in the channel length means variation in channel resistance; and, when the channel resistance is varied, it becomes difficult to stably improve the density of an output current. Thus, in manufacturing of the integrated circuit for which consolidation of a fine CMOS and a medium/high-voltage MOSFET is premised, the body region of the medium/high-voltage MOSFET cannot be formed by using the gate electrode as a mask since large thermal load cannot be applied after formation of the gate electrode. As a result, a problematic point that the channel length and the threshold voltage are varied becomes evident. When the channel length and the threshold voltage are varied, it becomes difficult to realize stable circuit operations conforming design specifications and to improve the density of the output current.

### SUMMARY OF THE INVENTION

A preferred aim of the present invention is to provide technique by which stable circuit operations conforming design specifications can be realized and the density of an output current can be improved by suppressing variations in the channel length and threshold voltage of a medium/high-voltage MOSFET in an integrated circuit (semiconductor device) for which consolidation of a fine CMOS and the medium/high-voltage MOSFET is premised.

The above and other preferred aims and novel characteristics of the present invention will be apparent from the description of the present specification and the accompanying drawings.

The typical ones of the inventions disclosed in the present application will be briefly described as follows.

A semiconductor device according to one aspect comprises comprising a field-effect transistor,the field-effect transistor having: a) a semiconductor substrate of a first conductivity type; (b) a body region of a second conductivity type formed in the semiconductor substrate; (c) a source region of the first conductivity type formed in a surface of the semiconductor substrate so as to be included in the body region in a planar view; (d) a channel region of the second conductivity type adjacent to the source region and formed in the surface of the semiconductor substrate so as to be included in the body region in the planar view; (e) a gate insulating film formed at least on the channel region; and (f) a gate electrode formed on the gate insulating film.

The width of the channel region sandwiched by the source region and the body region and/or a first semiconductor region of the first conductivity type adjacent to the channel region in a horizontal direction parallel to the surface of the semiconductor substrate is larger than or equal to 1/5 of a predetermined value and smaller than or equal to the predetermined value.

When the body region is divided into an upper-layer body region and a lower-layer body region, an end of the lower-layer body region is projecting to the outside more than an end of the upper-layer body region.

Preferably, the predetermined value is chosen according to the thickness of the gate electrode so that the width of the channel region sandwiched by the source region and the body region in a horizontal direction parallel to the surface of the semiconductor substrate is larger than or equal to 1/5 times the thickness of the gate electrode and smaller than or equal to the thickness of the gate electrode.

Preferably, the predetermined value is 500nm so that the width of the channel region sandwiched by the source region and the body region in a horizontal direction parallel to the surface of the semiconductor substrate is larger than or equal to 100 nm and smaller than or equal to 500 nm.

Preferable, the field-effect transistor further has the first semiconductor region of the first conductivity type adjacent to the channel region, formed in the surface of the semiconductor substrate so as to be included in the body region in the planar view, and electrically connected to the semiconductor substrate.

Preferably, the gate insulating film is formed at least on the channel region and the first semiconductor region.

Preferably, the width of the channel region sandwiched by the source region and the first semiconductor region in a horizontal direction parallel to the surface of the semiconductor substrate is larger than or equal to 1/5 of the predetermined value and smaller than or equal to the predetermined value.

Preferably, the predetermined value is chosen according to the thickness of the gate electrode so that the width of the channel region sandwiched by the source region and the first semiconductor region in a horizontal direction parallel to the surface of the semiconductor substrate is larger than or equal to 1/5 times the thickness of the gate electrode and smaller than or equal to the thickness of the gate electrode.

Preferably, the predetermined value is 500nm so that the width of the channel region sandwiched by the source region and the first semiconductor region in a horizontal direction parallel to the surface of the semiconductor substrate is larger than or equal to 100 nm and smaller than or equal to 500 nm.

Accordingly, the typical aspects of the inventions disclosed in the present application will be briefly described as follows.

A semiconductor device of the present invention is a semiconductor device including a field-effect transistor. Here, the field-effect transistor has: (a) a semiconductor substrate of a first conductivity type; (b) a body region of a second conductivity type formed in the semiconductor substrate; and (c) a source region of the first conductivity type formed in a surface of the semiconductor substrate so as to be included in the body region in a planar view. In addition, the field- effect transistor has: (d) a channel region of the second conductivity type adjacent to the source region and formed in the surface of the semiconductor substrate so as to be included in the body region in the planar view; and (e) a first semiconductor region of the first conductivity type adjacent to the channel region, formed in the surface of the semiconductor substrate so as to be included in the body region in the planar view, and electrically connected to the semiconductor substrate. The field-effect transistor further has: (f) a gate insulating film formed at least on the channel region and the first semiconductor region; and (g) a gate electrode formed on the gate insulating film. Herein, the width of the channel region sandwiched by the source region and the first semiconductor region in a horizontal direction parallel to the surface of the semiconductor substrate is larger than or equal to 1/5 times the thickness of the gate electrode and smaller than or equal to the thickness of the gate electrode; and, when the body region is divided into an upper-layer body region and a lower-layer body region, an end of the lower-layer body region is projecting to the outside more than an end of the upper-layer body region.

A semiconductor device of the present invention is a semiconductor device including a field-effect transistor. Here, the field-effect transistor has: (a) a semiconductor substrate of a first conductivity type; (b) a body region of a second conductivity type formed in the semiconductor substrate; and (c) a source region of the first conductivity type formed in a surface of the semiconductor substrate so as to be included in the body region in a planar view. In addition, the field-effect transistor has: (d) a channel region of the second conductivity type adjacent to the source region and formed in the surface of the semiconductor substrate so as to be included in the body region in the planar view; and (e) a first semiconductor region of the first conductivity type adjacent to the channel region, formed in the surface of the semiconductor substrate so as to be included in the body region in the planar view, and electrically connected to the semiconductor substrate. The field-effect transistor further has: (f) a gate insulating film formed at least on the channel region and the first semiconductor region; and (g) a gate electrode formed on the gate insulating film. Here, the width of the channel region sandwiched by the source region and the first semiconductor region in a horizontal direction parallel to the surface of the semiconductor substrate is larger than or equal to 100 nm and smaller than or equal to 500 nm; and, when the body region is divided into an upper-layer body region and a lower-layer body region, an end of the lower-layer body region is projecting to the outside more than an end of the upper-layer body region.

A semiconductor device of the present invention is a semiconductor device including a field-effect transistor. Here, the field-effect transistor has: (a) a semiconductor substrate of a first conductivity type; (b) a body region of a second conductivity type formed in the semiconductor substrate; and (c) a source region of the first conductivity type formed in a surface of the semiconductor substrate so as to be included in the body region in a planar view. In addition, the field-effect transistor has: (d) a channel region of the second conductivity type adjacent to the source region and formed in the surface of the semiconductor substrate so as to be included in the body region in the planar view; (e) a gate insulating film formed at least on the channel region; and (f) a gate electrode formed on the gate insulating film. Here, the width of the channel region sandwiched by the source region and the body region in a horizontal direction parallel to the surface of the semiconductor substrate is larger than or equal to 1/5 times the thickness of the gate electrode and smaller than or equal to the thickness of the gate electrode; and, when the body region is divided into an upper-layer body region and a lower-layer body region, an end of the lower-layer body region is projecting to the outside more than an end of the upper-layer body region.

A semiconductor device of the present invention is a semiconductor device including a field-effect transistor. Here, the field-effect transistor has: (a) a semiconductor substrate of a first conductivity type; (b) a body region of a second conductivity type formed in the semiconductor substrate; and (c) a source region of the first conductivity type formed in a surface of the semiconductor substrate so as to be included in the body region in a planar view. In addition, the field-effect transistor has: (d) a channel region of the second conductivity type adjacent to the source region and formed in the surface of the semiconductor substrate so as to be included in the body region in the planar view; (e) a gate insulating film formed at least on the channel region; and (f) a gate electrode formed on the gate insulating film. Here, the width of the channel region sandwiched by the source region and the body region in a horizontal direction parallel to the surface of the semiconductor substrate is larger than or equal to 100 nm and smaller than or equal to 500 nm; and, when the body region is divided into an upper-layer body region and a lower-layer body region, an end of the lower-layer body region is projecting to the outside more than an end of the upper-layer body region.

Preferably, in the above aspects, the impurity concentration of the first semiconductor region is higher than the impurity concentration of the semiconductor substrate.

Preferably, in the above aspects, in a stacking direction perpendicular to the surface of the semiconductor substrate, the first semiconductor region is structured to be sandwiched by the body region and the gate electrode via the gate insulating film.

Preferably, in the above aspects, the impurity concentration of the channel region is higher than the impurity concentration of the body region.

The effects obtained by typical aspects of the present invention will be briefly described below.

Stable circuit operations conforming design specifications can be realized and the density of an output current can be improved by suppressing variations in the channel length and threshold voltage of a medium/high-voltage MOSFET in an integrated circuit (semiconductor device) for which consolidation of a fine CMOS and the medium/high-voltage MOSFET is premised.

### BRIEF DESCRIPTIONS OF THE DRAWINGS

FIG. 1 is a cross-sectional view showing a device structure of a medium/high-voltage MOSFET in a first embodiment of the present invention;
FIG. 2 is an enlarged view enlarging part of FIG. 1;
FIG. 3 is a graph showing impurity concentration distribution at a line A1-A2 of FIG. 2;
FIG. 4 is a graph showing the relation between the width of a channel region and a threshold voltage and the relation between the width of the channel region and an output current;
FIG. 5 is a cross-sectional view showing a manufacturing step of a semiconductor device in the first embodiment;
FIG. 6 is a cross-sectional view showing a manufacturing step of the semiconductor device continued from FIG. 5;
FIG. 7 is a cross-sectional view showing a manufacturing step of the semiconductor device continued from FIG. 6;
FIG. 8 is a cross-sectional view showing a manufacturing step of the semiconductor device continued from FIG. 7;
FIG. 9 is a cross-sectional view showing a manufacturing step of the semiconductor device continued from FIG. 8;
FIG. 10 is a cross-sectional view showing a manufacturing step of the semiconductor device continued from FIG. 9;
FIG. 11 is a cross-sectional view showing a manufacturing step of the semiconductor device continued from FIG. 10;
FIG. 12 is a cross-sectional view showing a manufacturing step of the semiconductor device continued from FIG. 11;
FIG. 13 is a cross-sectional view showing a device structure of a medium/high-voltage MOSFET in a second embodiment;
FIG. 14 is an enlarged view enlarging part of FIG. 13;
FIG. 15 is a graph showing impurity concentration distribution at a line B1-B2 of FIG. 14;
FIG. 16 is a cross-sectional view showing a manufacturing step of a semiconductor device in the second embodiment;
FIG. 17 is a cross-sectional view showing a manufacturing step of the semiconductor device continued from FIG. 16;
FIG. 18 is a cross-sectional view showing a manufacturing step of the semiconductor device continued from FIG. 17;
FIG. 19 is a cross-sectional view showing a manufacturing step of the semiconductor device continued from FIG. 18;
FIG. 20 is a cross-sectional view showing a manufacturing step of the semiconductor device continued from FIG. 19;
FIG. 21 is a cross-sectional view showing a manufacturing step of the semiconductor device continued from FIG. 20;
FIG. 22 is a cross-sectional view showing a manufacturing step of the semiconductor device continued from FIG. 21;
FIG. 23 is a cross-sectional view showing a manufacturing step of the semiconductor device continued from FIG. 22;
FIG. 24 is a drawing showing an example in which the medium/high-voltage MOSFET of the present invention is applied to an output-stage circuit of an integrated circuit in which a digital circuit and an analog circuit are consolidated; and
FIG. 25 is a drawing showing a configuration in which output-stage circuits are formed to have multi-channels.

### DESCRIPTIONS OF THE PREFERRED EMBODIMENTS

In the embodiments described below, the invention will be described in a plurality of sections or embodiments when required as a matter of convenience. However, these sections or embodiments are not irrelevant to each other unless otherwise stated, and the one relates to the entire or a part of the other as a modification example, details, or a supplementary explanation thereof.

Also, in the embodiments described below, when referring to the number of elements (including number of pieces, values, amount, range, and the like), the number of the elements is not limited to a specific number unless otherwise stated or except the case where the number is apparently limited to a specific number in principle. The number larger or smaller than the specified number is also applicable.

Further, in the embodiments described below, it goes without saying that the components (including element steps) are not always indispensable unless otherwise stated or except the case where the components are apparently indispensable in principle.

Similarly, in the embodiments described below, when the shape of the components, positional relation thereof, and the like are mentioned, the substantially approximate and similar shapes and the like are included therein unless otherwise stated or except the case where it is conceivable that they are apparently excluded in principle. The same goes for the numerical value and the range described above.

Also, components having the same function are denoted by the same reference symbols throughout the drawings for describing the embodiments, and the repetitive description thereof is omitted. Note that, in some drawings used in the embodiments, hatching is used even in a plan view so as to make the drawings easy to see.

### (First Embodiment)

### <Device Structure of Medium/High-Voltage MOSFET>

A device structure of a medium/high-voltage MOSFET in a present first embodiment will be described with reference to the drawings. First, in the present specification, for example, a MOSFET having a breakdown voltage between a source region and a drain region of 20 V to 200 V-class is assumed as an example of the medium/high-voltage MOSFET to give explanation. However, the present invention is not limited thereto, and the device structure in the present first embodiment can be applied to various MOSFETs.

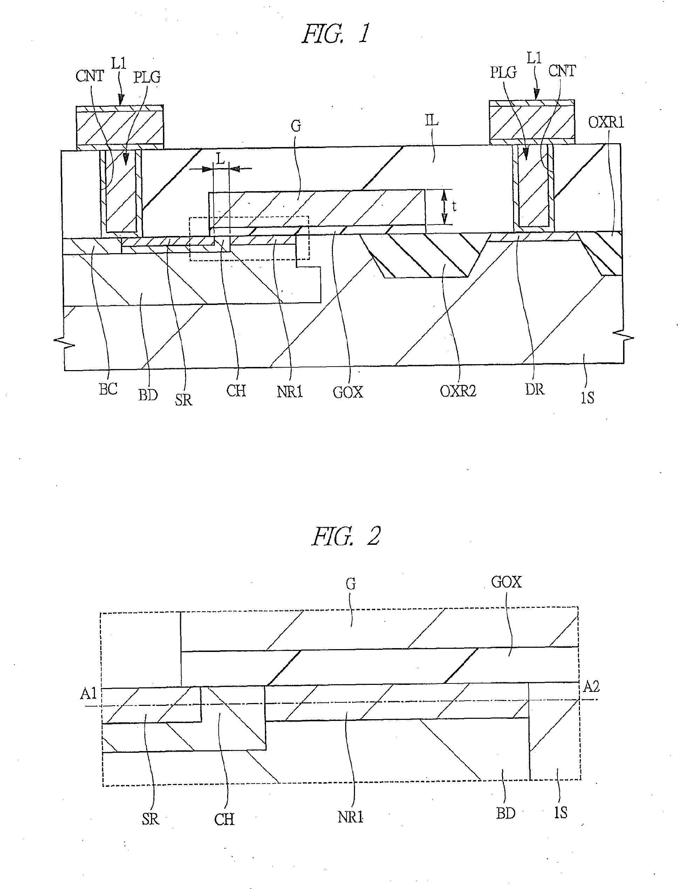

FIG. 1 is a cross-sectional view showing a device structure of the medium/high-voltage MOSFET in the present first embodiment. As shown in FIG. 1, first, the medium/high-voltage MOSFET in the present first embodiment is formed on a semiconductor substrate 1S to which an n-type impurity such as phosphorous (P) or arsenic (As) is introduced. Specifically, an oxide-film region OXR1 is formed in an element formation surface (surface, upper surface) side of the semiconductor substrate 1S, and the medium/high-voltage MOSFET is formed in an active region isolated by the oxide-film region OR1. As shown in FIG. 1, an oxide-film region OXR2 is formed in the active region isolated by the oxide-film region OXR1, and a drain region DR is formed in a right-side region of the oxide-film region OXR2. The drain region DR is formed of an n-type semiconductor region to which, for example, phosphorous (P) or arsenic (As) is introduced, and the impurity concentration of the drain region DR is higher than the impurity concentration of the semiconductor substrate 1S.

On the other hand, a body region BD is formed in the semiconductor substrate 1S so as to be away from a left-side region of the oxide-film region OXR2 by a predetermined distance. The body region BD is formed of a p-type semiconductor region to which a p-type impurity such as boron (B) is introduced. A source region SR is formed in the surface of the semiconductor substrate 1S so as to be included in the body region BD in a planar view. The source region SR is formed of an n-type semiconductor region to which an n-type impurity such as phosphorous (P) or arsenic (As) is introduced. Furthermore, in the present first embodiment, a channel region CH is formed in the surface of the semiconductor substrate 1S so as to be adjacent to the source region SR and included in the body region BD in the planar view. The channel region CH is formed of a p-type semiconductor region to which a p-type impurity such as boron (B) is introduced. Furthermore, an n-type semiconductor region NR1 is formed in the surface of the semiconductor substrate 1S so as to be adjacent to the channel region CH and included in the body region BD in the planar view. The n-type semiconductor region NR1 is formed so as to be electrically connected to the semiconductor substrate 1S. The source region SR is sandwiched by the channel region CH and a body contact region BC, and the body contact region BC is formed so as to be adjacent to the source region SR. The body contact region BC is formed in the surface of the semiconductor substrate 1S so as to be included in the body region BD in the planar view. The body contact region BC is formed of a p-type semiconductor region to which a p-type impurity such as boron (B) is introduced, and the impurity concentration of the body contact region BC is higher than the impurity concentration of the body region BD.

Furthermore, a gate insulating film GOX is formed at least from the part above the channel region CH and above the n-type semiconductor region NR1 to the part above the oxide-film region OXR2, and a gate electrode G is formed above the gate insulating film GOX. The gate insulating film GOX is formed of, for example, a silicon oxide film, but is not limited thereto; for example, the gate insulating film can be formed of a high-permittivity film having a higher permittivity than that of a silicon oxide film. The gate electrode G is formed of, for example, a polysilicon film. In the above-described manner, the medium/high-voltage MOSFET of the present first embodiment is formed on the semiconductor substrate 1S.

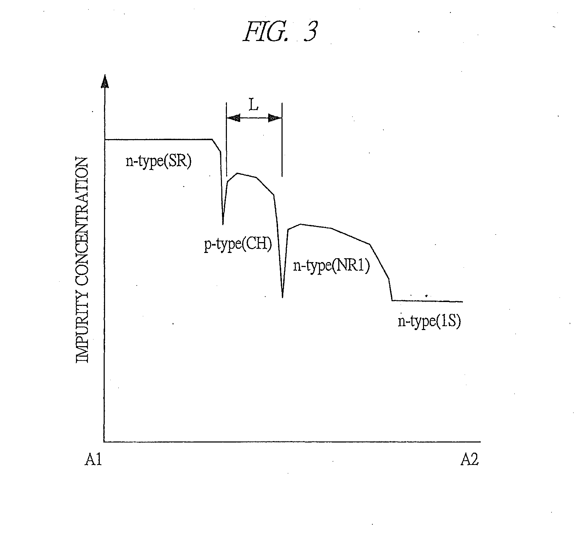

FIG. 2 is a diagram showing, in an enlarged manner, the region surrounded by a broken line of FIG. 1. A line A1-A2 shown in FIG. 2 is a line extending from the source region SR to the semiconductor substrate 1S through the channel region CH and the n-type semiconductor region NR1. Hereinafter, impurity concentration distribution along the line A1-A2 will be described. FIG. 3 is a graph showing the impurity concentration distribution at the line A1-A2 of FIG. 2. As shown in FIG. 3, the source region SR is an n-type semiconductor region to which an n-type impurity is introduced and has the highest impurity concentration of the n-type impurity. The channel region CH adjacent to the source region SR is a p-type semiconductor region to which a p-type impurity is introduced and has an impurity concentration of the p-type impurity lower than the impurity concentration of the n-type impurity introduced to the source region SR. An n-type impurity is introduced to the n-type semiconductor region NR1 adj acent to the channel region CH, and the impurity concentration of the n-type impurity introduced to the n-type semiconductor region NR1 is lower than the impurity concentration of the p-type impurity introduced to the channel region CH. An n-type impurity is introduced to the semiconductor substrate 1S adjacent to the n-type semiconductor region NR1, and the impurity concentration of the n-type impurity introduced to the semiconductor substrate 1S is lower than the impurity concentration of the n-type impurity introduced to the n-type semiconductor region NR1.

Next, a wiring structure electrically connected to the medium/high-voltage MOSFET formed on the semiconductor substrate 1S will be described. In FIG. 1, an interlayer insulating film IL formed of, for example, a silicon oxide film is formed on the semiconductor substrate 1S covering the medium/high-voltage MOSFET, and contact holes CNT penetrating through the interlayer insulating film IL are formed in the interlayer insulating film IL. The plurality of contact holes CNT are formed. For example, the contact hole CNT that reaches the drain region DR of the medium/high-voltage MOSFET and the contact hole CNT that reaches the body contact region BC and the source region SR of the medium/high-voltage MOSFET are formed. A barrier conductor film composed of multi-layer films of, for example, a titanium film and a titanium nitride film is formed on an inner wall of each of the contact holes CNT, and a metal film composed of, for example, a tungsten film is formed so as to fill the interior of the contact hole CNT via the barrier conductor film. Plugs PLG are formed by burying the barrier conductor film and the metal film in the contact holes CNT in this manner. Wiring L1 is formed on the interlayer insulating film IL in which the plugs PLG are formed. The wiring L1 can be composed of multi-layer films of, for example, a titanium nitride film, an aluminum film, and a titanium nitride film or can be composed of buried wiring (damascene wiring) composed of a copper film buried in the interlayer insulating film IL.

Here, the impurity concentrations of, for example, the source region SR and the drain region DR are higher than the impurity concentration of the semiconductor substrate 1S for the reasons described below. The source region SR and the drain region DR are semiconductor regions, and the plug PLG in contact with the source region SR or the drain region DR is formed of a metal film. If the work function (Fermi level) of the metal film is smaller than the Fermi level of the semiconductor, the contact between the metal film constituting the plug PLG and the semiconductor region constituting the source region SR or the drain region DR is resistive contact (ohmic contact), and no problem is caused. However, for example, if the work function of the metal constituting the plug PLG is larger than the Fermi level of the semiconductor constituting the source region SR or the drain region DR, a Schottky junction is formed in the connection region of the source region SR and the plug PLG or in the connection region of the drain region DR and the plug PLG. In the Schottky junction, the Schottky barrier thereof is reduced and allows flow of a current if a negative electric potential is applied to the semiconductor side and a positive electric potential is applied to the metal side; on the other hand, the Schottky barrier is increased and does not allow flow of a current if a positive electric potential is applied to the semiconductor side and a negative electric potential is applied to the metal side. In other words, the Schottky junction has a rectifying function. However, the source region SR or the drain region DR of the medium/high-voltage MOSFET and the plug PLG have to be in resistive contact not having the rectifying function. Therefore, from the viewpoint of changing the Schottky contact to resistive contact, the impurity concentration of the semiconductor region constituting the source region SR or the drain region DR is a high concentration. The reason therefor is that the width of a depletion layer generated in the Schottky junction can be reduced when the impurity concentration of the semiconductor region is a high concentration, and, as a result, even when a reverse-direction voltage is applied, a tunneling current flows. Thus, even in the case of the Schottky junction, the width of the depletion layer is reduced when the impurity concentration of the semiconductor region is high; and, even when a reverse-direction voltage is applied, a tunneling current flows. As a result, the rectifying function of the Schottky junction is eliminated, and resistive contact without the rectifying function can be realized. Therefore, the reason the impurity concentrations of the source region SR and the drain region DR are higher than the impurity concentration of the semiconductor substrate 1S is to achieve resistive contact (ohmic contact). For a similar reason, the impurity concentration of the body contact region BC is higher than the impurity concentration of the body region BD to achieve resistive contact.

For example, an n-type contact region having a high impurity concentration may be provided to be included in the source region SR so as to realize resistive contact between the n-type contact region and the plug PLG. However, if the impurity concentration of the source region SR is high enough to achieve resistive contact, the n-type contact region is not required to be provided. More specifically, if the impurity concentration of the source region SR is not high enough to achieve the resistive contact with the plug PLG, the n-type contact region having an impurity concentration higher than the impurity concentration of the source region SR is required to be provided so as to be included in the source region SR; however, if the impurity concentration of the source region SR is high enough to achieve the resistive contact, the n-type contact region becomes unnecessary.

In the medium/high-voltage MOSFET in the present first embodiment, the source region SR and the body contact region BC are electrically connected to the same plug PLG, and the same electric potential is applied to the source region SR and the body contact region BC. Specifically, a reference electric potential (GND electric potential, 0 V) is applied to the source region SR and the body contact region BC.

The reason the reference electric potential is supplied to the body contact region BC in this case is as described below. The body contact region BC is electrically connected to the channel region CH and the body region BD; therefore, if the reference electric potential is applied to the body contact region BC, the reference electric potential is also applied to the channel region CH. As a result, the electric potential of the channel region CH (back gate) is stably fixed to the reference electric potential. As a result, when an on-voltage is applied to the gate electrode G, a stable electric potential difference is applied between the gate electrode G and the channel region CH, and the threshold voltage of the medium/high-voltage MOSFET is stabilized. Thus, the reason for applying the reference electric potential to the body contact region BC is to stabilize the threshold voltage of the medium/high-voltage MOSFET by applying the reference electric potential to the channel region CH electrically connected to the body contact region BC.

One reason the source region SR which is the n-type semiconductor region and the body contact region BC which is the p-type semiconductor region are at the same electric potential is to suppress turn-on of a parasitic bipolar transistor formed of the semiconductor substrate 1S (n-type semiconductor region NR1) (serving as a collector region), the channel region CH (serving as a base region), and the source region SR (serving as an emitter region). Therefore, if the same electric potential is applied to the source region SR and the body contact region BC, the same electric potential is applied to the source region SR and the channel region CH. Therefore, neither forward bias nor reverse bias is applied to the pn junction formed at the boundary between the source region SR, which is the n-type semiconductor region, and the channel region CH, which is the p-type semiconductor region; and, for example, a built-in potential of about 0.7 V is formed thereat. For example, different electric potentials are supplied to the source region SR and the channel region CH, and forward bias is applied to the pn junction formed at the boundary between the source region SR, which is the n-type semiconductor region, and the channel region CH, which is the p-type semiconductor region; if this state is considered, the built-in potential formed at the pn junction in this case is lower than 0.7 V. This means that the parasitic bipolar transistor can be easily turned on. Therefore, the source region SR, which is the n-type semiconductor region, and the body contact region BC, which is the p-type semiconductor region, are put at the same electric potential so that the parasitic bipolar transistor is not easily tuned on.

### <Features in the Present First Embodiment>

The medium/high-voltage MOSFET in the present first embodiment is configured in the above-described manner, and a characteristic configuration will be described in detail below with reference to the drawings.

In FIG. 1, a feature of the present first embodiment is that the width (channel length) of the channel region CH is reduced. Specifically, as shown in FIG. 1, the width of the channel region CH planarly overlapped with the gate electrode G is represented by L, and the thickness of the gate electrode G is represented by t; in this case, the channel region CH is formed so that the width L of the channel region CH is larger than or equal to 1/5 times the thickness t of the gate electrode G and smaller than or equal to the thickness t. As a result, the width L of the channel region CH can be reduced, and variation in the threshold voltage can be reduced. The thickness t of the gate electrode G formed on the gate insulating film GOX is, for example, about 150 to 250 nm, and a sufficiently short channel length can be ensured in the present first embodiment as compared with conventional techniques. As a result, the medium/high-voltage MOSFET having a stable threshold voltage can be provided.

For example, in some cases, an insulating film is formed on the gate electrode G shown in FIG. 1. There is a tendency that the film thickness of the insulating film formed on the gate electrode G becomes thin along with miniaturization of the semiconductor device, and the total film thickness of the gate insulating film GOX, the gate electrode G, and the insulating film is 500 nm or less. Also in this case, a sufficiently short channel length compared with conventional techniques can be ensured, for example, by forming the width L of the channel region CH to be 100 to 500 nm or less. As a result, a medium/high-voltage MOSFET having a stable threshold voltage can be provided.

Hereinafter, first, a qualitative reason that variations in the threshold voltage can be reduced by reducing the width L of the channel region CH will be explained.

For example, in manufacturing steps of a single medium/high-voltage MOSFET for which consolidation with a fine CMOS is not assumed, a gate electrode is used as a mask after the gate electrode is formed so as to implant a conductive-type impurity into a semiconductor substrate in a manner aligned with the gate electrode, and the semiconductor substrate is subjected to high-temperature thermal treatment. Thus, a body region including a channel region can be formed by thermally diffusing the implanted conductive-type impurity. In this step, relative misalignment between source region and the body region, which are similarly formed by using the gate electrode as a mask, does not occur; therefore, there is an advantage that the channel length and threshold voltage thereof are stably determined. However, in this manufacturing step, large thermal load is applied after the gate electrode is formed since the body region is formed by diffusing the conductive-type impurity, which has been introduced into the surface of the semiconductor substrate, to a deep region of the semiconductor substrate. Therefore, it is difficult to use this step in manufacturing of the integrated circuit for which consolidation with a fine CMOS is premised to be carried out.

Therefore, in manufacturing of the integrated circuit for which consolidation with a fine CMOS is premised to be carried out, before the gate electrode is formed, a step of forming the body region of the medium/high-voltage MOSFET is employed like the present first embodiment. However, in this case, the gate electrode cannot be used as a mask; therefore, different masks are used respectively, for example, as the mask for forming the gate electrode and the body region that determines the threshold voltage and the mask for forming the source region, and relative misalignment between the masks occur. As a result, the channel length and the peak density of the impurity that determines the threshold voltage are changed, and the threshold voltage is varied.

Therefore, in the present first embodiment, the body region BD of the medium/high-voltage MOSFET is formed before the gate electrode G is formed; however, the body region BD and the channel region CH are configured to be formed in different steps instead of forming the body region BD together with the channel region CH. More specifically, in the present first embodiment, the body region BD that requires large thermal treatment is formed before the gate electrode G is formed, wherein the channel region CH is formed by using the formed gate electrode G as a mask after the gate electrode G is formed instead of forming the channel region CH together with the body region BD. The channel region CH is formed in the vicinity of the surface of the semiconductor substrate 1S and therefore requires comparatively small thermal treatment for diffusing the conductive-type impurity. Therefore, in manufacturing steps of the integrated circuit for which consolidation with a fine CMOS is premised to be carried out, even when the channel region CH is formed after the gate electrode G is formed, the influence exerted on the fine CMOS can be reduced.

In this manner, in the present first embodiment, using the step of forming the channel region CH after forming the gate electrode G is premised. In this case, the source region SR is also formed by using the same gate electrode G as a mask; therefore, relative misalignment between the source region SR and the channel region CH does not occur. The threshold voltage of the medium/high-voltage MOSFET is considered to be stably determined for this reason. Thus, in this step, the channel region CH and the source region SR are formed by using the same gate electrode G as a mask; therefore, variations in the threshold voltage caused by the misalignment of the channel region CH and the source region SR can be effectively suppressed.

In the present first embodiment, the width L of the channel region CH formed in a region immediately below the gate electrode G is reduced as much as possible. Specifically, an impurity is obliquely implanted while using the gate electrode G as a mask, and the implantation energy, the implantation amount, and the implantation angle thereof are adjusted, thereby forming the channel region CH so that the with L of the channel region CH is larger than or equal to 1/5 times the thickness t of the gate electrode G and smaller than or equal to the thickness t when the width of the channel region CH planarly overlapped with the gate electrode G is L and the thickness of the gate electrode G is t as shown in FIG. 1.

Subsequently, another feature of the present first embodiment are that, as shown in FIG. 1, the width L of the channel region CH formed in the region immediately below the gate electrode G is reduced as much as possible and that the n-type semiconductor region NR1 is provided so as to be adjacent to the channel region CH.

For example, a voltage equal to or higher than the threshold voltage is applied to the gate electrode G of the medium/high-voltage MOSFET, an inversion layer is formed in the channel region CH, the inversion layer achieves conduction between the source region SR and the drain region DR, and a current (drain current) flows from the drain region DR to the source region SR. In this process, the inversion layer has a comparatively large electric resistance since the cross sectional area of the cross section perpendicular to the direction in which the current flows is small. Therefore, for example, if the width L of the channel region CH is comparatively large, the length of the inversion layer in the direction in which the current flows is also long, and the cross sectional area of the inversion layer in the cross section perpendicular to the direction in which the current flows is small as described above. Thus, the on-state resistance of the medium/high-voltage MOSFET is unwillingly increased, and the density of the output current is thus reduced.

On the other hand, in the present first embodiment, the width L of the channel region CH is reduced; therefore, the length of the inversion layer can be shortened compared with the case in which the width L of the channel region CH is comparatively large. This means that, according to the present first embodiment, the channel resistance caused by the inversion layer formed in the channel region CH can be reduced. Furthermore, in the present first embodiment, the n-type semiconductor region NR1 is provided in the region in which the channel region CH is not formed in the region immediately below the gate electrode G. The impurity concentration of the n-type semiconductor region NR1 is higher than the impurity concentration of the semiconductor substrate 1S. Therefore, in the present first embodiment, the on-state resistance of the medium/high-voltage MOSFET can be reduced also by providing the n-type semiconductor region NR1 having an impurity concentration higher than that of the semiconductor substrate 1S. Thus, in the present first embodiment, the on-state resistance of the medium/high-voltage MOSFET can be significantly reduced by synergetic effects of the point that the length of the inversion layer is reduced by reducing the width L of the channel region CH and the point that the n-type semiconductor region NR1 having an impurity concentration higher than that of the semiconductor substrate 1S is provided in the region in which the channel region CH is not formed in the region immediately below the gate electrode G. As a result, according to the medium/high-voltage MOSFET of the present first embodiment, the on-state resistance can be reduced, and the density of an output current can be therefore improved.

In the present first embodiment, the impurity concentration distribution of the semiconductor substrate 1S is not particularly mentioned. However, since the semiconductor substrate 1S functions as a drift region in which a drain current flows in the present first embodiment, the impurity concentration of the partial local region of the semiconductor substrate 1S may be high in order to reduce a resistance in the drift region (drift resistance).

Explanation has been given above from qualitative viewpoints about the points that the threshold voltage of the medium/high-voltage MOSFET can be stabilized substantially at a designed value and that stable circuit operations conforming design specifications can be realized by using the first characteristic configuration of forming the channel region CH so that the width L of the channel region CH is larger than or equal to 1/5 times the thickness t of the gate electrode G and smaller than or equal to the thickness t, where the width of the channel region CH planarly overlapping the gate electrode G is L, and the thickness of the gate electrode G is t. Furthermore, in addition to the above-described first characteristic configuration, explanation has been given from qualitative viewpoints about the point that the density of the output current of the medium/high-voltage MOSFET can be improved by employing the second characteristic configuration of providing the n-type semiconductor region NR1, which has the impurity concentration higher than that of the semiconductor substrate 1S, in the region in which the channel region CH is not formed in the region immediately below the gate electrode G.

Hereinafter, the point that the density of the output current can be improved while suppressing increase in the threshold voltage by employing the above-described first characteristic configuration and the second characteristic configuration will be explained from quantitative viewpoints.

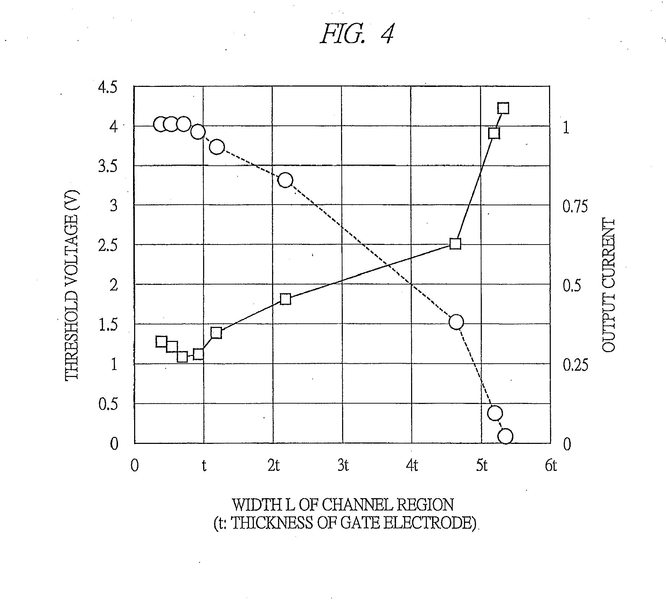

FIG. 4 is a graph showing a relation between the width L of the channel region CH and the threshold voltage and the relation between the width L of the channel region CH and the output current. In FIG. 4, the horizontal axis shows the width L of the channel region CH by using the thickness t of the gate electrode G. The vertical axis (left side) shows the threshold voltage (V), and the vertical axis (right side) shows the output current. In FIG. 4, formation of the channel region CH by ion-implanting a p-type impurity (boron) is premised and the width L of the channel region CH is changed by changing the implantation energy of boron (B). FIG. 4 shows results obtained by subjecting the threshold voltage and the output current to device simulations in the case in which the width L of the channel region CH is changed. Herein, relative values of the drain current in the case the gate voltage is 5 V and the drain voltage is 20 V are shown as the output current.

First, the relation between the width L of the channel region CH and the threshold voltage in FIG. 4 will be explained. In FIG. 4, the relation between the width L of the channel region CH and the threshold voltage is shown by a solid line. As shown in FIG. 4, when the width L of the channel region CH is 0.2 t to t, it can be understood that variation in the threshold voltage is small and that the threshold voltage is low. It can be understood that, as the width L of the channel region CH is increased from t to 5t, the threshold voltage is increased; and, furthermore, when the width L of the channel region CH becomes 5t or more, the threshold voltage is rapidly increased. This is a result that matches the qualitative explanation. In other words, the relation between the width L of the channel region CH and the threshold voltage shown in FIG. 4 proves that the qualitative explanation described above is reasonable. Therefore, when the width of the channel region CH planarly overlapped with the gate electrode G is L and the thickness of the gate electrode G is t, it is conceived to be described by FIG. 4 also quantitatively that the threshold voltage can be stabilized to a low value and stable circuit operations conforming design specifications can be realized by forming the channel region CH so that the width L of the channel region CH is larger than or equal to 1/5 times the thickness t of the gate electrode G and smaller than or equal to the thickness t.

Subsequently, the relation between the width L of the channel region CH and the output current in FIG. 4 will be described. In FIG. 4, the relation between the width L of the channel region CH and the output current is shown by a broken line. As shown in FIG. 4, it can be understood that, when the width L of the channel region CH is 0.2 t to t, the output current is relatively large and that the output current is gradually decreased as the width L of the channel region CH becomes larger than or equal to t. Thus, this conceivably proves the qualitative explanation that the channel resistance is increased as the width L (channel length) of the channel region CH is increased, where the output current is reduced as a result. Therefore, when the width of the channel region CH planarly overlapped with the gate electrode G is L and the thickness of the gate electrode G is t, it is conceived to be described by FIG. 4 also quantitatively that the on-state resistance can be reduced by forming the channel region CH so that the width L of the channel region CH is larger than or equal to 1/5 times the thickness t of the gate electrode G and smaller than or equal to the thickness t and, the output current can be improved as a result.

### <Arrangement 1 for Breakdown-Voltage Improvement>

As described above, the features of the present first embodiment reside in the point that the width L of the channel region CH is made to be larger than or equal to 1/5 the thickness t of the gate electrode G and smaller than or equal to the thickness t and the point that the n-type semiconductor region NR1 having the impurity concentration higher than that of the semiconductor substrate 1S in the region in which the channel region CH is not formed in the region immediately below the gate electrode G. In the present first embodiment, these characteristic points serve are premised, and, furthermore, arrangements are made from the viewpoint of breakdown-voltage improvement. Therefore, these arrangements will be described.

Specifically, in the medium/high-voltage MOSFET in the present first embodiment shown in FIG. 1, electric-field concentration occurs at an end surface of the oxide-film region OXR2 (the end surface opposed to the drain region DR). In the region in which electric fields are concentrated in this manner, an avalanche amplification phenomenon easily occurs. Thus, in the present first embodiment, it is important to suppress the electric-field concentration that occurs at the end surface of the oxide-film region OXR2.

In the medium/high-voltage MOSFET in the present first embodiment shown in FIG. 1, the n-type semiconductor region NR1 is provided in the region immediately below the gate electrode G. The n-type semiconductor region NR1 has an impurity concentration higher than that of the semiconductor substrate 1S, which is a drift region, and has a function of reducing the on-state resistance. Therefore, from the viewpoint of reducing the on-state resistance, it is conceived to be desirable to extend the n-type semiconductor region NR1 further to the region in contact with the surface end of the oxide-film region OXR2 instead of forming the n-type semiconductor region NR1 only up to the boundary region of the body region BD and the semiconductor substrate 1S as shown in FIG. 1. However, the surface end of the oxide-film region OXR2 is the region where electric-field concentration occurs; and, if the high-concentration n-type semiconductor region NR1 is formed up to this region, the electric-field concentration is increased. More specifically, the higher the concentration of the semiconductor region, the more easily electric-field concentration occurs; therefore, if the n-type semiconductor region NR1 is extended to the region in contact with the surface end of the oxide-film region OXR2, the avalanche amplification phenomenon caused by the electric-field concentration easily occurs. Therefore, in the present first embodiment, from the viewpoint of reducing the on-state resistance, the n-type semiconductor region NR1 is provided in the region immediately below the gate electrode G; on the other hand, from the viewpoint of suppressing the avalanche amplification phenomenon caused by the electric-field concentration, the n-type semiconductor region NR1 is formed only up to the boundary region of the body region BD and the semiconductor region 1s without extending the region NR1 to the region in contact with the surface end of the oxide-film region OXR2. Thus, in the present first embodiment, reduction in the on-state resistance and suppression of the electric-field concentration are both achieved.

### <Arrangement 2 for Withstand-Voltage Improvement>

In the present first embodiment, an arrangement of preventing breakdown of the medium/high-voltage MOSFET caused by punch-through is made. Specifically, in the present first embodiment, as shown in FIG. 1, when the body region BD is divided into a shallow upper-layer body region and a deep lower-layer body region, an end of the lower-layer body region has a structure projecting to the drain region DR side compared with an end of the upper-layer body region. In other words, it can be also said that the end of the upper-layer body region is configured to be indented (recessed) compared with the end of the lower-layer body region, and the upper-layer body region has a structure sandwiched by the lower-layer body region and the gate electrode G. Moreover, since the n-type semiconductor region NR1 is formed so as to be included in the upper-layer body region, it can be also said that the n-type semiconductor region NR1 is sandwiched by the body region BD and the gate electrode G.

In the present first embodiment, such configurations are used so that the end of the upper-layer body region (end of the n-type semiconductor region NR1) is sandwiched by the lower-layer body region and the gate electrode G and recessed; therefore, the electric field from the drain region DR does not easily enter the interior of the n-type semiconductor region NR1, and, since the substantially the same electric potential (for example, reference electric potential (0 V)) is applied to the body region BD and the gate electrode G, an increase in the electric potential of the n-type semiconductor region NR1 can be suppressed. This means that the reverse bias applied to the pn junction formed at the boundary region of the n-type semiconductor region NR1 and the channel region CH is reduced. The larger the reverse bias, the more the depletion layer is extended; therefore, reduction in the reverse bias means that the extension of the depletion layer is suppressed. Therefore, in the present first embodiment, even though the width L of the channel region CH is formed to be small so as to be larger than or equal to 1/5 times the thickness t of the gate electrode G and smaller than or equal to the thickness t, the depletion layer extending to the channel region CH can be suppressed from reaching the source region SR, and, as a result, punch-through can be suppressed. In other words, in the present first embodiment, the end of the upper-layer body region (end of the n-type semiconductor region NR1) is configured to be sandwiched by the lower-layer body region and the gate electrode G and recessed, and the substantially the same electric potential is configured to be applied to the body region BD and the gate electrode G, thereby suppressing punch-through, and, as a result, breakdown of the medium/high-voltage MOSFET caused by punch-through can be prevented.

### <Manufacturing Method of Medium/High-Voltage MOSFET>

The medium/high-voltage MOSFET in the present first embodiment is configured in the manner described above, and a manufacturing method thereof will be described below with reference to the drawings.

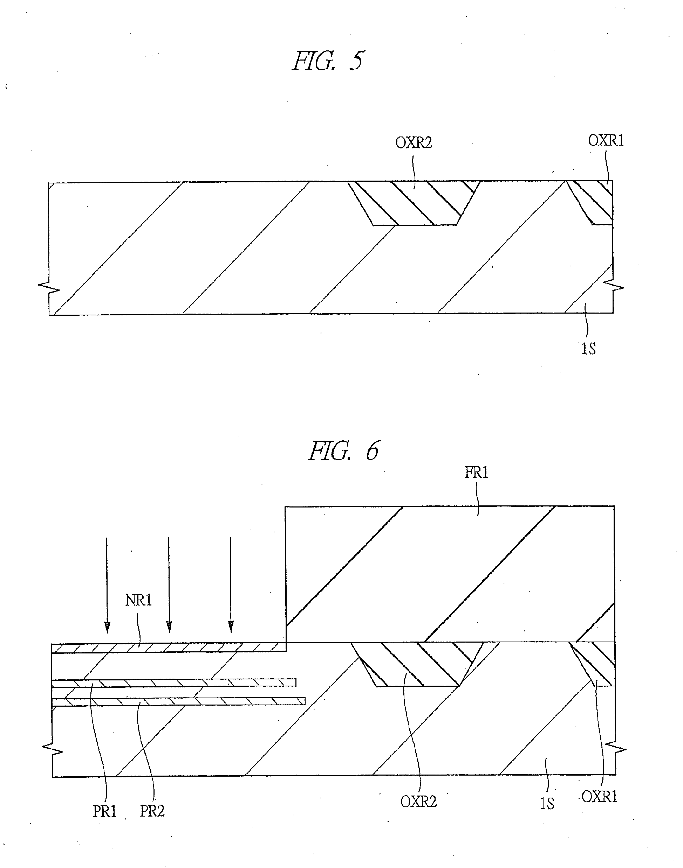

First, as shown in FIG. 5, a semiconductor substrate 1S composed of single crystal silicon to which an n-type impurity such as phosphorous (P) or arsenic (As) is introduced is prepared. At this point, the semiconductor substrate 1S is in the state of a semiconductor wafer having a substantially disk-like shape. Then, an oxide-film region OXR1 and an oxide-film region OXR2 mutually separating elements are formed in the semiconductor substrate 1S. The oxide-film region OXR1 is provided so that elements do not interfere with each other. The oxide-film region OXR1 and the oxide-film region OXR2 can be formed, for example, by using a STI (shallow trench isolation) method. For example, in the STI method, element isolation regions are formed in the following manner. Element isolation grooves are formed in the semiconductor substrate 1S by using photolithography techniques and etching techniques. Then, a silicon oxide film is formed on the semiconductor substrate so as to bury the element isolation grooves. Then, the unnecessary silicon oxide film formed on the semiconductor substrate is removed by a chemical mechanical polishing method (CMP). As a result, the oxide-film region OXR1 and the oxide-film region OXR2 in which the silicon oxide film is buried only in the element isolation grooves can be formed.

Next, as shown in FIG. 6, a resist film FR1 is applied on the semiconductor substrate 1S, and the resist film FR1 is subjected to exposure/development treatment, thereby patterning the resist film FR1. The patterning of the resist film FR1 is carried out so as to form an opening in the region in which the n-type semiconductor region NR1 is to be formed and in the region in which the body region BD is to be formed. Then, an n-type semiconductor region NR1 is formed in the surface of the semiconductor substrate 1S by an ion implantation method using the patterned resist film FR1 as a mask. The n-type semiconductor region NR1 is formed by introducing, for example, phosphorous (P) into the semiconductor substrate 1S. Then, the same patterned resist film FR1 is used as a mask to form a p-type semiconductor region PR1 and a p-type semiconductor region PR2. The p-type semiconductor region PR1 and the p-type semiconductor region PR2 can be formed, for example, by introducing boron (B) into the semiconductor substrate 1S. Herein, the average projection range of phosphorous (P) for forming the n-type semiconductor region NR1 is configured to be shorter than the average projection range of boron (B) for forming the p-type semiconductor region PR1 and the p-type semiconductor region PR2. The p-type semiconductor region PR1 and the p-type semiconductor region PR2 are formed by changing the energy of implanted boron (B).

In this step, the same mask (resist film FR1) is used to form the n-type semiconductor region NR1, the p-type semiconductor region PR1, and the p-type semiconductor region PR2; therefore, relative misalignment between these regions can be eliminated. In the step shown in FIG. 6, the reasons phosphorous (P) and boron (B) are implanted by using the same mask before the gate electrode G is formed are that: (1) if phosphorous (P) and boron (B) are implanted by different masks, designing has to take misalignment mutually between the masks into consideration and (2) if the n-type semiconductor region NR1 is formed while using the oxide-film region OXR2 as a mask, the high-concentration n-type semiconductor region NR1 is formed to the surface end of the oxide-film region OXR2, electric-field concentration occurs as a result at the surface end of the oxide-film region OXR2, and the breakdown voltage is reduced.

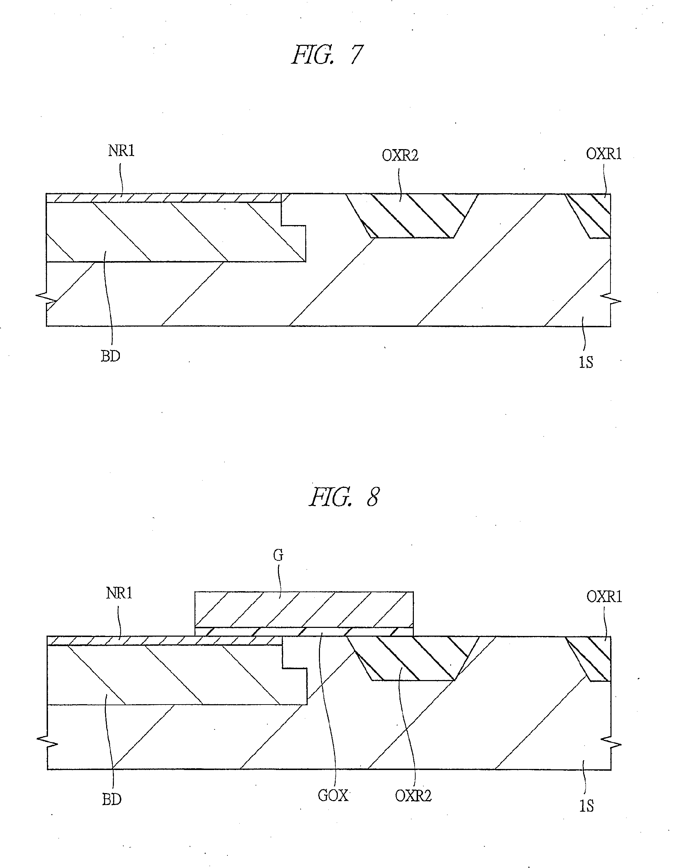

Subsequently, as shown in FIG. 7, implanted phosphorous (P) and boron (B) are diffused by carrying out thermal treatment so that the n-type semiconductor region NR1 and a body region BD in contact with the n-type semiconductor region NR1 can be formed. Herein, the n-type semiconductor region NR1, the p-type semiconductor region PR1, and the p-type semiconductor region PR2 are formed by using the same mask; however, the depths at which they are formed in the semiconductor substrate 1S are mutually different. The region that is formed in a deeper region is formed so as to extend to the layer below the mask; therefore, when thermal diffusion treatment shown in FIG. 7 is carried out, the structure in which the lower layer of the body region BD projects to the oxide-film region OXR2 side is obtained. Thus, the end of the n-type semiconductor region NR1 is configured to be recessed and sandwiched between the projecting lower layer of the body region BD and a gate electrode G formed in a later-described step; therefore, the electric field from a drain region DR formed in a later-described step is prevented from easily entering the interior of the n-type semiconductor region NR1. As a result, the electric-field intensity in the n-type semiconductor region NR1 can be weakened. In this manner, in the present first embodiment, the n-type semiconductor region NR1 and the body region BD are formed using the same mask (resist film FR1); therefore, relative misalignment between the n-type semiconductor region NR1 and the body region BD is eliminated, and manufacturing variation caused by misalignment can be reduced.

The impurity implantation conditions for forming the n-type semiconductor region NR1, the p-type semiconductor region PR1, and the p-type semiconductor region PR2 and the thermal treatment conditions for forming the body region BD are set so that the n-type semiconductor region NR1 and the body region BD are in contact with each other and that a later-described channel region CH and the body region BD are electrically connected to each other. The p-type semiconductor region PR2 is a region formed in order to improve the breakdown voltage by expanding the body region BD in the depth direction of the semiconductor substrate 1S. Therefore, implantation conditions are determined depending on the breakdown-voltage specification of the medium/high-voltage MOSFET, and, in some cases, the p-type semiconductor region PR2 is formed by plural times of ion implantation with different implantation energy.

In the present first embodiment, the reasons the n-type semiconductor region NR1 having a concentration higher than the impurity concentration of the semiconductor substrate 1S is formed are: (1) to reduce electric resistance as much as possible since the n-type semiconductor region NR1 has a comparatively thin-long shape with respect to the direction in which a current flows; (2) to determine the position of the channel region CH by the angle of implantation and the amount of implantation, where the channel region CH that determines the threshold voltage is formed by p-type impurity implantation after formation of the gate electrode G; and (3) to prevent loss of the n-type semiconductor region NR1 due to impurity diffusion from the p-type semiconductor region PR1 in the thermal treatment step upon formation of the body region BD.

Then, as shown in FIG. 8, a gate insulating film GOX is formed on the surface of the semiconductor substrate 1S, and the gate electrode G is formed on the gate insulating film GOX. The gate insulating film GOX is formed of, for example, a silicon oxide film, but not limited thereto; and the gate insulating film GOX can be also formed of a high-permittivity film having a permittivity higher than that of a silicon oxide film. The gate electrode G can be formed of, for example, a polysilicon film. As described above, in the present first embodiment, before the gate electrode G is formed, the step of forming the body region BD of the medium/high-voltage MOSFET which is a step with large thermal load is carried out. Therefore, since application of large thermal load to a fine CMOS can be suppressed, reliability of a semiconductor device in which the medium/high-voltage MOSFET and the fine CMOS are consolidated can be improved.

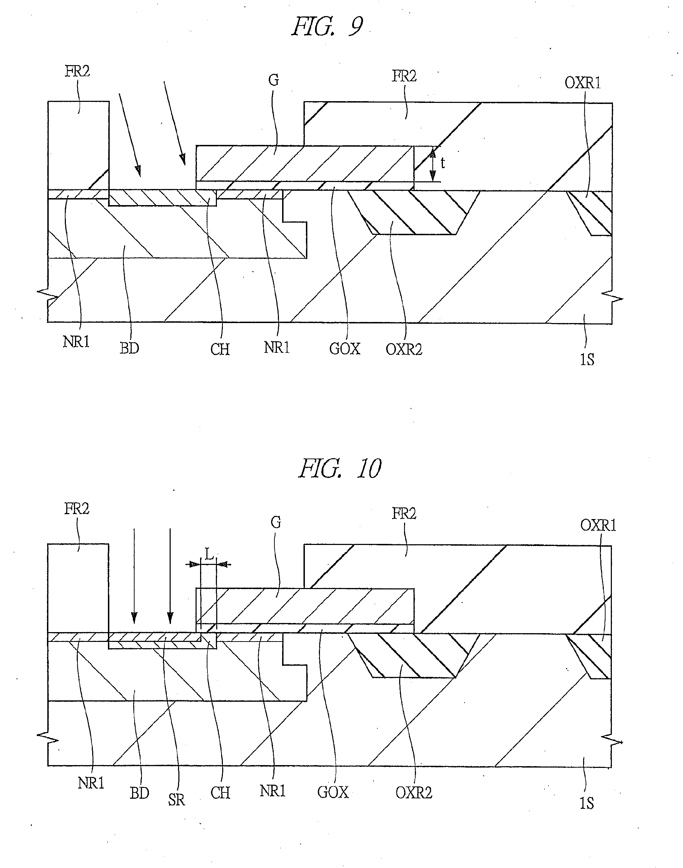

Subsequently, as shown in FIG. 9, a resist film FR2 is applied onto the semiconductor substrate 1S on which the gate electrode G is formed, and the applied resist film FR2 is subjected to exposure/development treatment, thereby patterning the resist film FR2. The patterning of the resist film FR2 is carried out so as to form an opening partially above a source formation region, which is adjacent to the gate electrode G, and the gate electrode G. Then, ion implantation using the patterned resist film FR2 as a mask is carried out.

Specifically, first, as shown in FIG. 9, a p-type impurity such as boron (B) is implanted from an oblique direction of the semiconductor substrate 1S with the energy by which the width of the channel region CH becomes shorter than the thickness of the gate electrode G. As a result, the channel region CH can be formed by using the resist film FR2 as a mask. Specifically, the channel region CH having the width smaller than or equal to the thickness of the gate electrode G can be realized by setting the implantation energy of boron (B) to a value by which the gate electrode G is not transmitted through. Then, as shown in FIG. 10, an n-type impurity such as arsenic (As) is implanted from a perpendicular direction of the semiconductor substrate 1S while using the same resist film FR2 as a mask. As a result, a source region SR aligned with the gate electrode G and shallower than the channel region CH can be formed.

Thus, the relative misalignment between the source region SR and the channel region CH can be eliminated since the source region SR and the channel region CH are formed by using the same gate electrode G as a mask. Therefore, the threshold voltage of design specifications can be stably realized by adjusting the dose of the impurities introduced to the source region SR and the channel region CH. Furthermore, in the present first embodiment, when the width of the channel region CH planarly overlapped with the gate electrode G is L and the thickness of the gate electrode G is t, the channel region CH can be formed so that the width L of the channel region CH is larger than or equal to 1/5 times the thickness t of the gate electrode G and smaller than or equal to the thickness t; therefore, the channel resistance of the medium/high-voltage MOSFET can be stabilized to a low value.

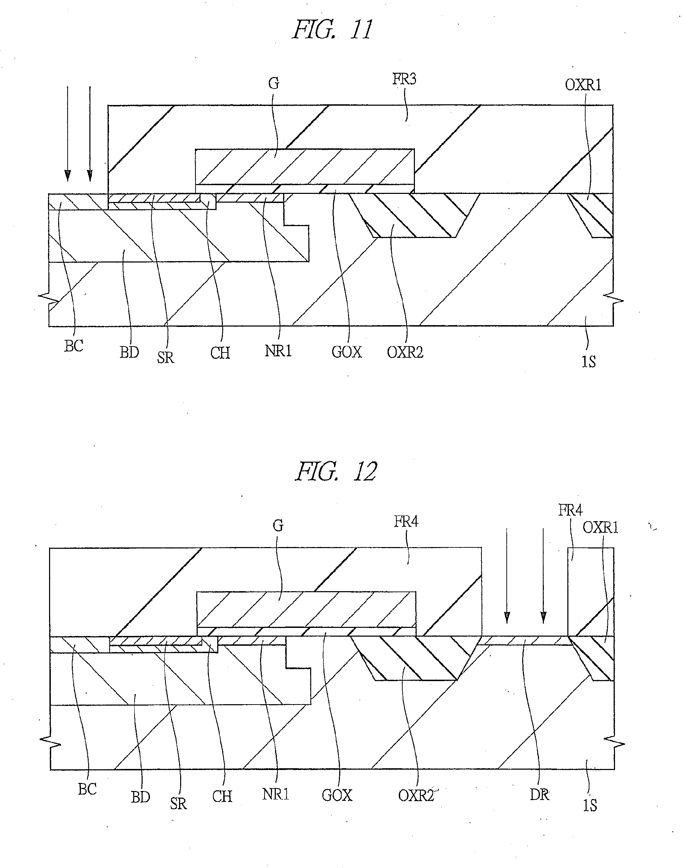

Then, as shown in FIG. 11, a resist film FR3 is applied onto the semiconductor substrate 1S, and the applied resist film FR3 is subjected to exposure/development treatment, thereby patterning the resist film FR3. The patterning of the resist film FR3 is carried out so that an opening is formed in the region in which the body contact region BC is to be formed. Then, the body contact region BC adjacent to the source region SR is formed in the surface of the semiconductor substrate 1S by ion implantation using the patterned resist film FR3 as a mask. The body contact region BC can be formed, for example, by introducing a p-type impurity such as boron (B) to the semiconductor substrate 1S.

Then, as shown in FIG. 12, a resist film FR4 is applied onto the semiconductor substrate 1S, and the applied resist film FR4 is subjected to exposure/development treatment, thereby patterning the resist film FR4. The patterning of the resist film FR4 is carried out so as to form an opening in the region in which a drain region DR is to be formed. Then, the drain region DR is formed in the surface of the semiconductor substrate 1S by ion implantation using the patterned resist film FR4 as a mask. The drain region DR can be formed, for example, by introducing an n-type impurity such as phosphorous (P) or arsenic (As) to the semiconductor substrate 1S.

Next, wiring steps will be described with reference to FIG. 1. As shown in FIG. 1, an interlayer insulating film IL is formed on a principal surface of the semiconductor substrate 1S. This interlayer insulating film IL is formed of, for example, a multi-layer film of an ozone TEOS film, which is formed by a thermal CVD method using ozone and TEOS (tetra ethyl ortho silicate) as raw materials, and a plasma TEOS film, which is formed by a plasma CVD method using TEOS provided on the ozone TEOS film as the raw materials. Then, the surface of the interlayer insulating film IL is planarized by using, for example, a CMP (Chemical Mechanical Polishing) method.

Subsequently, contact holes CNT are formed in the interlayer insulating film IL by using photolithography techniques and etching techniques.

Then, a titanium/titanium-nitride film is formed on the interlayer insulating film IL including the bottom surfaces and inner walls of the contact holes CNT. The titanium/titanium-nitride film is composed of a multi-layer film of a titanium film and a titanium nitride film and can be formed by, for example, using a sputtering method. The titanium/titanium-nitride film has a so-called barrier characteristic that prevents, for example, tungsten serving as a material of a film buried in a later step from diffusing into silicon.

Then, a tungsten film is formed on the entire surface of the principal surface of the semiconductor substrate 1S so as to bury the contact holes CNT. The tungsten film can be formed by using, for example, a CVD method. Then, plugs PLG can be formed by removing the unnecessary titanium/titanium-nitride film and tungsten film formed on the interlayer insulating film IL, for example, by the CMP method.

Then, a titanium/titanium-nitride film, an aluminum film, and a titanium/titanium-nitride film are sequentially formed on the interlayer insulating film IL and the plugs PLG. These films can be formed by using, for example, the sputtering method. Subsequently, patterning of these films is carried out by using photolithography techniques and etching techniques to form wiring L1. Thus, the wiring L1 composed of the aluminum film can be formed. Furthermore, wiring is formed in an upper layer of the wiring L1, but explanation thereof will be omitted herein. In this manner, the semiconductor device of the present first embodiment can be finally formed.

In the present first embodiment, an example in which the wiring L1 composed of the aluminum film has been described; however, the wiring L1 composed of a copper film may be formed.

In that case, for example, a second interlayer insulating film is formed on the interlayer insulating film IL in which the plugs PLG are formed. Then, grooves are formed in the second interlayer insulating film by using photolithography techniques and etching techniques. Then, a tantalum/tantalum-nitride film is formed on the second interlayer insulating film including the inside of the grooves. The tantalum/tantalum-nitride film can be formed, for example, by the sputtering method. Subsequently, a seed film composed of a thin copper film is formed on the tantalum/tantalum-nitride film, for example, by the sputtering method; then, a copper film is formed on the second interlayer insulating film, in which the grooves are formed, by an electrolytic plating method using the seed film as an electrode. Then, the copper film exposed above the second interlayer insulating film except for the copper film in the grooves is removed, for example, by polishing by a CMP method, thereby causing the copper film to remain only in the grooves formed in the second interlayer insulating film. Thus, the wiring L1 can be formed.

### <Effects in the Present First Embodiment>

According to the present first embodiment, below described effects can be obtained.
(1) In the present first embodiment, before the gate electrode G is formed, the step of forming the body region BD of the medium/high-voltage MOSFET which is a step with large thermal load is carried out. Therefore, since application of large thermal load to the fine CMOS can be suppressed, reliability of the semiconductor device in which the medium/high-voltage MOSFET and the fine CMOS are consolidated can be improved.
(2) In the present first embodiment, the source region SR and the channel region CH are formed by using the same gate electrode G as a mask; therefore, relative misalignment between the source region SR and the channel region CH can be eliminated. Therefore, the threshold voltage of design specifications can be stably realized by adjusting the dose of the impurities introduced to the source region SR and the channel region CH.
(3) In the present first embodiment, when the width of the channel region CH planarly overlapped with the gate electrode G is L and the thickness of the gate electrode G is t, the channel region CH can be formed so that the width L of the channel region CH is larger than or equal to 1/5 times the thickness t of the gate electrode G or smaller than or equal to the thickness t. Therefore, the channel resistance of the medium/high-voltage MOSFET can be stabilized to a low value.
(4) In the present first embodiment, the on-state resistance of the medium/high-voltage MOSFET can be reduced by providing the n-type semiconductor region NR1, which has an impurity concentration higher than that of the semiconductor substrate 1S, in the region in which the channel region CH is not formed in the region immediately below the gate electrode G; and, as a result, the density of the output current can be improved.
(5) In the present first embodiment, the n-type semiconductor region NR1 is provided in the region immediately below the gate electrode G from the viewpoint of reducing the on-state resistance; on the other hand, from the viewpoint of suppressing the avalanche amplification phenomenon due to electric-field concentration, the n-type semiconductor region NR1 is not extended to the region in contact with the surface end of the oxide-film region OXR2, but is formed only up to the boundary region of the body region BD and the semiconductor substrate 1S. Thus, in the present first embodiment, a certain level of reduction in the on-state resistance and prevention of breakdown-voltage reduction can be both achieved.
(6) In the present first embodiment, the end of the upper-layer body region (end of the n-type semiconductor region NR1) is configured to be sandwiched between the lower-layer body region and the gate electrode G and recessed, and substantially the same electric potential is configured to be applied to the body region BD and the gate electrode G. Therefore, punch-through can be suppressed, and, as a result, breakdown of the medium/high-voltage MOSFET caused by punch-through can be prevented.
(7) According to the present first embodiment, a chip size can be downsized by the synergetic effects of the point that a correction circuit, etc. that correct performance variation become unnecessary since manufacturing variation of the medium/high-voltage MOSFET can be suppressed and the point that performance improvement can be realized by improving the density of the output current of the medium/high-voltage MOSFET; and cost can be also reduced by the downsizing of the chip size.

### (Second Embodiment)

In the above-described first embodiment, the example in which the n-type semiconductor region NR1 having an impurity concentration higher than that of the semiconductor substrate 1S is provided in the region in which the channel region CH is not formed in the region immediately below the gate electrode G has been described. However, in the present second embodiment, an example in which the above-described n-type semiconductor region NR1 is not provided will be described. The device structure of a medium/high-voltage MOSFET in the present second embodiment is substantially similar to the device structure of the medium/high-voltage MOSFET in the above-described first embodiment; therefore, different points will be mainly described below.

### <Characteristics of the Present Second Embodiment>

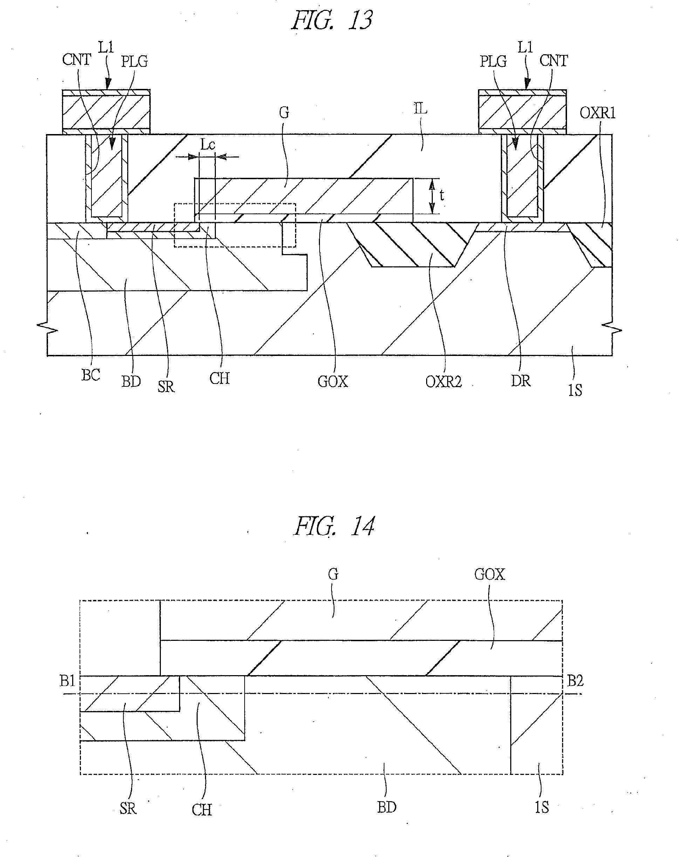

FIG. 13 is a cross-sectional view showing the device structure of the medium/high-voltage MOSFET in the present second embodiment. Also in the present second embodiment, as well as the above-described first embodiment, the width of the channel region CH (channel length) is reduced. Specifically, as shown in FIG. 13, when the width of the channel region CH planarly overlapped with the gate electrode G is Lc and the thickness of the gate electrode G is t, the channel region CH is formed so that the width Lc of the channel region CH is larger than or equal to 1/5 times the thickness t of the gate electrode G and smaller than or equal to the thickness t. As a result, the width Lc of the channel region CH can be reduced, and variations in the threshold voltage can be reduced. The thickness t of the gate electrode G formed on the gate insulating film GOX is, for example, about 150 nm to 250 nm, where a sufficiently short channel length compared with conventional techniques can be ensured also in the present second embodiment as well as the above-described first embodiment. As a result, the medium/high-voltage MOSFET having a stable threshold voltage can be provided.

In FIG. 13, the n-type semiconductor region NR1, which is formed in the above-described first embodiment, is not formed in the present second embodiment (see FIG. 1). More specifically, in the present second embodiment, the body region BD, which is a p-type semiconductor region, is formed in the region in which the channel region CH is not formed in the region immediately below the gate electrode G. A feature of the present second embodiment resides in a point that the impurity concentration of the body region BD is lower than the impurity concentration of the channel region CH.

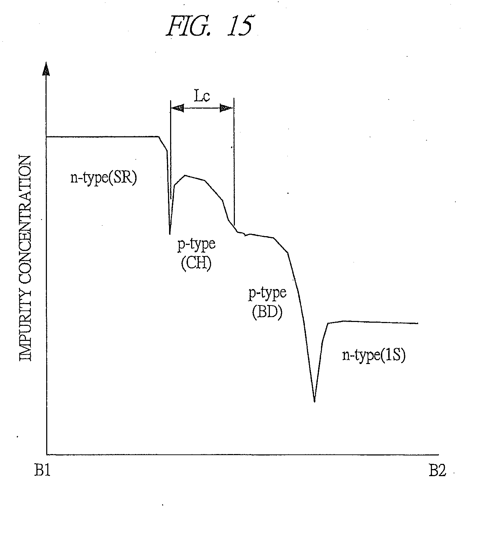

FIG. 14 is a drawing showing, in an enlarged manner, a region surrounded by a broken line of FIG. 13. A line B1-B2 shown in FIG. 14 is a line extending from the source region SR to the semiconductor substrate 1S through the channel region CH. Hereinafter, the impurity concentration distribution along the line B1-B2 will be described. FIG. 15 is a graph showing the impurity concentration distribution at the line B1-B2 of FIG. 14. As shown in FIG. 15, the source region SR is an n-type semiconductor region, to which an n-type impurity is introduced, and has the highest impurity concentration of the n-type impurity. The channel region CH adjacent to the source region SR is a p-type semiconductor region, to which a p-type impurity is introduced, and has an impurity concentration of the p-type impurity lower than the impurity concentration of the n-type impurity introduced to the source region SR. Next, a p-type impurity is introduced to the body region BD adjacent to the channel region CH, and the impurity concentration of the p-type impurity introduced to the body region BD is lower than the impurity concentration of the p-type impurity introduced to the channel region CH. An n-type impurity is introduced to the semiconductor substrate 1S adjacent to the body region BD, and the impurity concentration of the n-type impurity introduced to the semiconductor substrate 1S is lower than the impurity concentration of the p-type impurity introduced to the body region BD.

In the case in which the impurity concentration of the body region BD is lower than the impurity concentration of the channel region CH in this manner, for example, when an on-voltage is applied to the gate electrode G, the width of an inversion layer formed in the body region BD (width of a cross section perpendicular to the direction in which a current flow) can be caused to be larger than an inversion layer formed in the channel region CH. Therefore, the electric resistance of the inversion layer formed in the body region BD can be reduced, and the output current of the medium/high-voltage MOSFET can be improved.

In the above-described first embodiment, the on-state resistance is reduced by providing the n-type semiconductor region NR1 having the impurity concentration higher than that of the semiconductor substrate 1S in the region in which the channel region CH is not formed in the region immediately below the gate electrode G. On the other hand, in the present second embodiment, the on-state resistance is reduced by forming the body region BD, which has a concentration lower than the impurity concentration of the channel region CH, in the region in which the channel region CH is not formed in the region immediately below the gate electrode G.

The reason that the width of the inversion layer formed in the body region BD becomes larger than the width of the inversion layer formed in the channel region CH when the impurity concentration of the body region BD is lower than the impurity concentration of the channel region CH will be described.

First, in the case of a p-type semiconductor region, the Fermi level is present in the vicinity of an upper part of the valence band. The higher the concentration of the p-type impurity, the closer the Fermi level gets to the valence band. More specifically, the Fermi level of a p-type semiconductor region having a high concentration is present at a position closer to the valence band more than the Fermi level of a p-type semiconductor region having a low concentration. The mechanism of formation of an inversion layer is that, when a positive voltage is applied to the gate electrode G, the conduction band of the p-type semiconductor region is bent to the direction of the valence band; and, furthermore, when the positive voltage applied to the gate electrode G is increased, the bending of the conduction band of the p-type semiconductor region is also increased. This means that electrons are accumulated in the bent conduction band, and the inversion layer is therefore formed. More specifically, when an end of the conduction band of the p-type semiconductor region is bent, the end of the conduction band of the p-type semiconductor region gets closer to the Fermi level of the p-type semiconductor region to form a band structure of an n-type semiconductor region in a pseudo manner, and the inversion layer is formed. An important point herein is the position of the Fermi level of the p-type semiconductor region. Specifically, if the position of the Fermi level is at a high position (position away from the valence band), the inversion layer can be easily formed even with slight bending of the conduction band. In other words, if the position of the Fermi level is at a low position (position close to the valence band), the inversion layer is not formed unless the conduction band is considerably bent. More specifically, the Fermi level of the high-concentration p-type semiconductor region is present at a position closer to the valence band than the Fermi level of the low-concentration p-type semiconductor region is; therefore, according to the above-described mechanism, the high-concentration p-type semiconductor region less easily forms the inversion layer than the low-concentration p-type semiconductor region, and this means that the threshold voltage for forming the inversion layer is higher in the high-concentration p-type semiconductor region than in the low-concentration p-type semiconductor region. Therefore, since the impurity concentration of the body region BD is lower than the impurity concentration of the channel region CH in the case of the present second embodiment, when a gate voltage by which an inversion layer is formed in the surface of the channel region CH is applied to the gate electrode G, an inversion layer is already formed in the surface of the body region BD, the gate voltage significantly larger than the threshold voltage is applied to the body region BD, and the width of the inversion layer formed in the body region BD is therefore increased.

According to the present second embodiment, the electric resistance of the inversion layer formed in the body region BD can be reduced by the above-described mechanism, and the output current of the medium/high-voltage MOSFET can be improved.

### <Manufacturing Method of Medium/High-Voltage MOSFET>

The medium/high-voltage MOSFET in the present second embodiment is configured in the above-described manner, and a manufacturing method thereof will be described below with reference to the drawings.

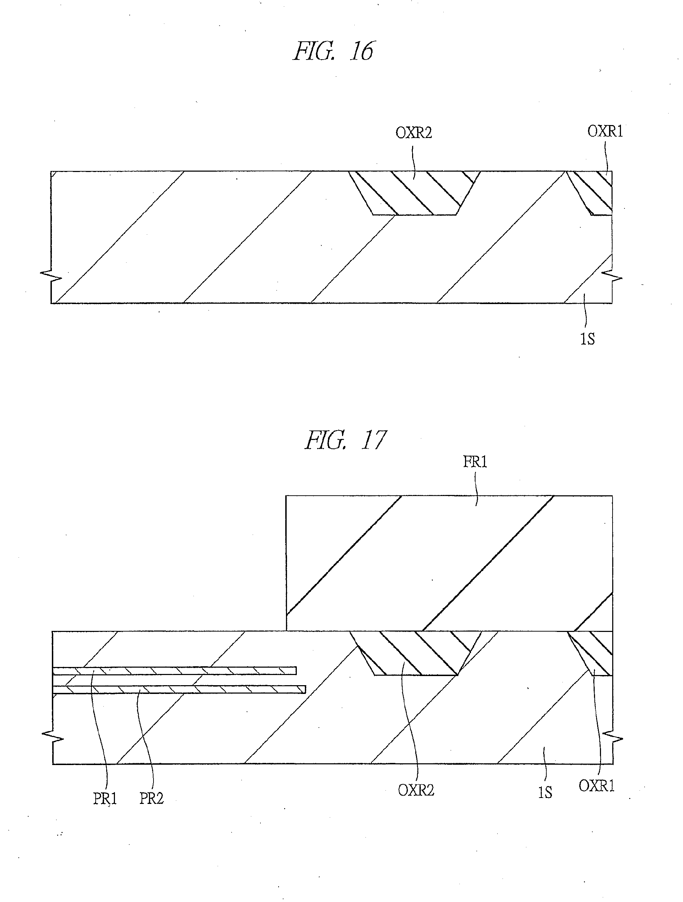

First, as shown in FIG. 16, a semiconductor substrate 1S composed of single crystal silicon to which an n-type impurity such as phosphorous (P) or arsenic (As) is introduced is prepared. At this point, the semiconductor substrate 1S is in the state of a semiconductor wafer having a substantially disk-like shape. Then, an oxide-film region OXR1 and an oxide-film region OXR2 which mutually isolate elements are formed in the semiconductor substrate 1S.

Then, as shown in FIG. 17, a resist film FR1 is applied onto the semiconductor substrate 1S, and the resist film FR1 is subjected to exposure/development treatment, thereby patterning the resist film FR1. The patterning of the resist film FR1 is carried out so as to form an opening in the region in which a body region BD is to be formed. Then, a p-type semiconductor region PR1 and a p-type semiconductor region PR2 are formed by the ion implantation method while using the patterned resist film FR1 as a mask. The p-type semiconductor region PR1 and the p-type semiconductor region PR2 can be formed, for example, by introducing boron (B) to the semiconductor substrate 1S.

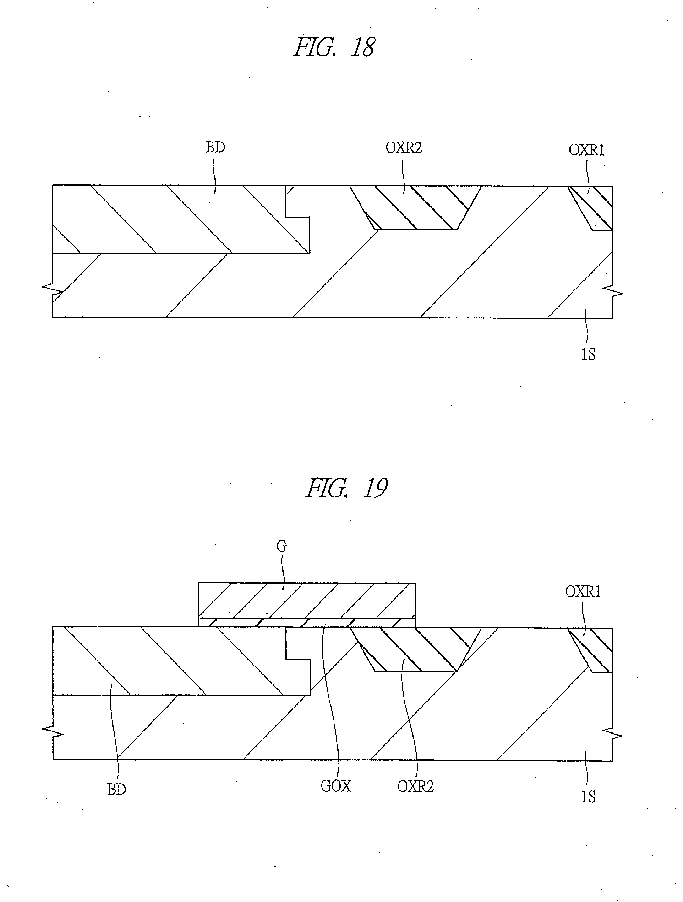

Subsequently, as shown in FIG. 18, the body region BD can be formed by diffusing the implanted boron (B) by carrying out thermal treatment.

Then, as shown in FIG. 19, a gate insulating film GOX is formed on the surface of the semiconductor substrate 1S, and a gate electrode G is formed on the gate insulating film GOX. The gate insulating film GOX is formed of, for example, a silicon oxide film, but is not limited thereto; and, for example, the gate insulating film GOX can be formed of a high-permittivity film having a permittivity higher than that of a silicon oxide film. The gate electrode G can be formed of, for example, a polysilicon film. As described above, in the present second embodiment, before the gate electrode G is formed, a step of forming the body region BD of the medium/high-voltage MOSFET which is a step with large thermal load is carried out. Therefore, since application of larger thermal load to the fine CMOS can be suppressed, reliability of the semiconductor device in which the medium/high-voltage MOSFET and the fine CMOS are consolidated can be improved.

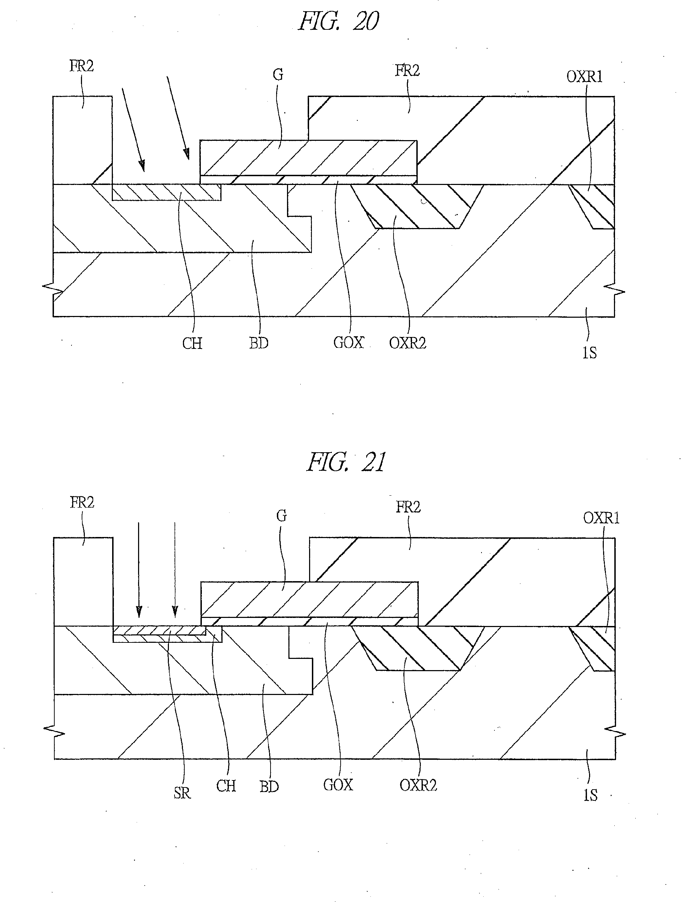

Subsequently, as shown in FIG. 20, a resist film FR2 is applied onto the semiconductor substrate 1S on which the gate electrode G is formed, and the applied resist film FR2 is subjected to exposure/development treatment, thereby patterning the resist film FR2. The patterning of the resist film FR2 is carried out so that an opening is formed partially above a source formation region, which is adjacent to the gate electrode G, and the gate electrode G. Then, ion implantation is carried out while using the patterned resist film FR2 as a mask.

Specifically, first, as shown in FIG. 20, for example, a p-type impurity such as boron (B) is implanted from an oblique direction of the semiconductor substrate 1S with the energy by which the width of the channel region CH becomes shorter than the thickness of the gate electrode G. As a result, the channel region CH can be formed by using the resist film FR2 as a mask. Specifically, the channel region CH having the width smaller than or equal to the thickness of the gate electrode G can be realized by setting the implantation energy of boron (B) to a value by which the gate electrode G is not transmitted through. Then, as shown in FIG. 21, for example, an n-type impurity such as arsenic (As) is implanted from a perpendicular direction of the semiconductor substrate 1S while using the same resist film FR2 as a mask. As a result, the source region SR aligned with the gate electrode G and shallower than the channel region CH can be formed.

Thus, the relative misalignment between the source region SR and the channel region CH can be eliminated since the source region SR and the channel region CH are formed by using the same gate electrode G as a mask. Therefore, the threshold voltage of design specifications can be stably realized by adjusting the dose of the impurities introduced to the source region SR and the channel region CH.

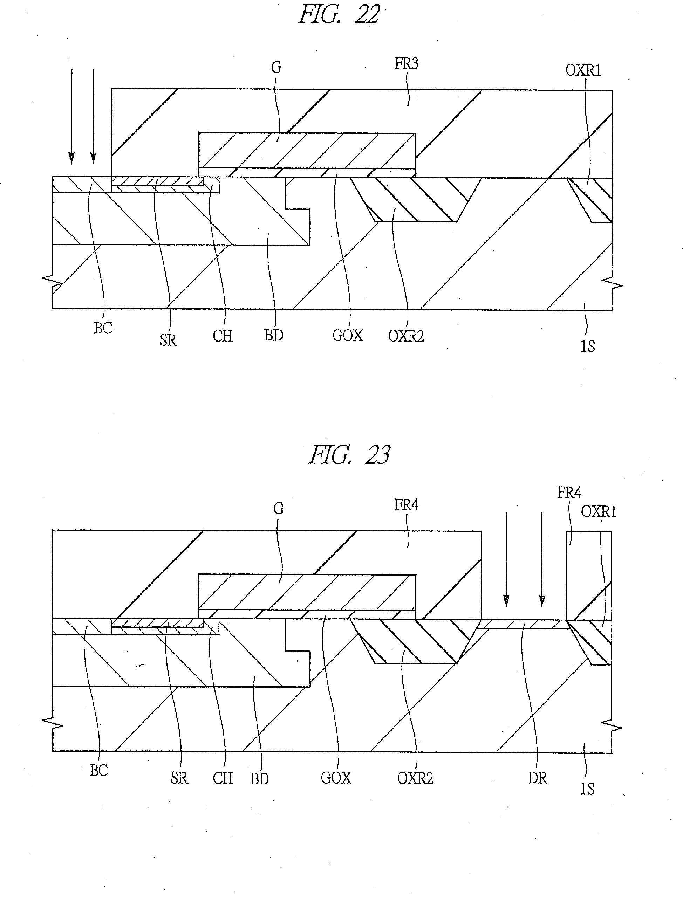

Then, as shown in FIG. 22, a resist film FR3 is applied onto the semiconductor substrate 1S, and the applied resist film FR3 is subjected to exposure/development treatment, thereby patterning the resist film FR3. The patterning of the resist film FR3 is carried out so that an opening is formed in the region in which the body contact region BC is to be formed. Then, the body contact region BC adjacent to the source region SR is formed in the surface of the semiconductor substrate 1S by ion implantation using the patterned resist film FR3 as a mask. The body contact region BC can be formed, for example, by introducing a p-type impurity such as boron (B) to the semiconductor substrate 1S.

Then, as shown in FIG. 23, a resist film FR4 is applied onto the semiconductor substrate 1S, and the applied resist film FR4 is subjected to exposure/development treatment, thereby patterning the resist film FR4. The patterning of the resist film FR4 is carried out so that an opening is formed in the region in which a drain region DR is to be formed. Then, the drain region DR is formed in the surface of the semiconductor substrate 1S by ion implantation using the patterned resist film FR4 as a mask. The drain region DR can be formed, for example, by introducing an n-type impurity such as phosphorous (P) or arsenic (As) to the semiconductor substrate 1S.

Then, a semiconductor device of the present second embodiment can be manufactured by forming a wiring structure as well as the above-described first embodiment. Also in the semiconductor device of the present second embodiment, effects similar to those of the semiconductor device of the above-described first embodiment can be obtained.

### (Third Embodiment)

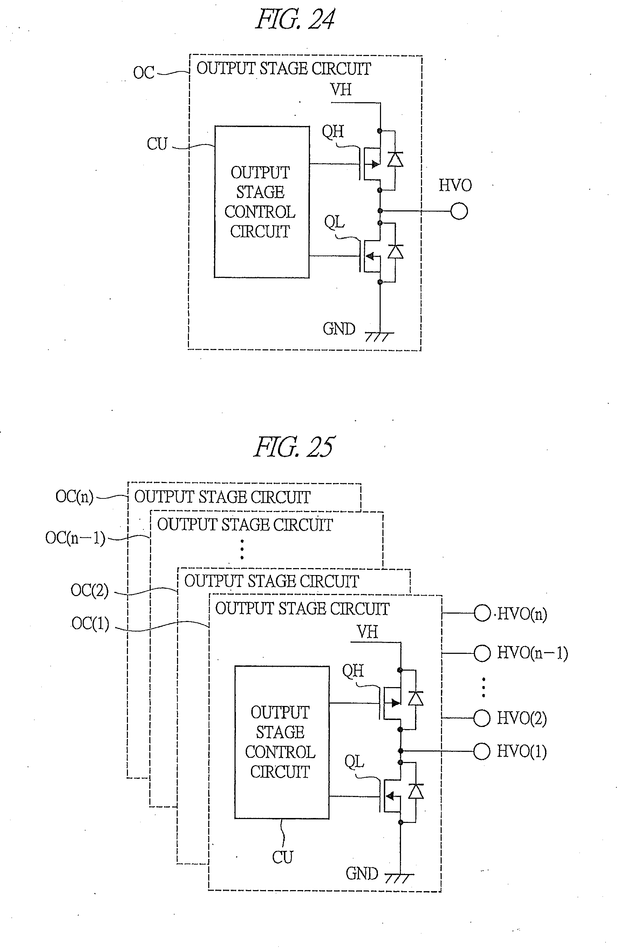

In the present third embodiment, application examples of the medium/high-voltage MOSFETs described in the above-described first embodiment and the second embodiment will be described. FIG. 24 is a drawing showing an example in which the medium/high-voltage MOSFET of the present invention is applied to an output-stage circuit of an integrated circuit in which a digital circuit and an analog circuit are consolidated. In FIG. 24, the output-stage circuit OC has a configuration in which a p-channel-type MOSFET QH and an n-channel-type MOSFET QL of the present invention are connected in series between a power source electric potential VH and a reference electric potential GND. In this case, the p-channel-type MOSFET QH is connected to the power source electric potential VH side, and the n-channel-type MOSFET QL is connected to the reference electric potential GND side. A connection node (connecting point) between the p-channel-type MOSFET QH and the n-channel-type MOSFET QL serves as an output terminal HVO. In the thus-configured p-channel-type MOSFET QH and the n-channel-type MOSFET QL, gate electrodes thereof are electrically connected to an output-stage control circuit CU, and switching of the p-channel-type MOSFET QH and the n-type-channel MOSFET QL is controlled by the control by the output-stage control circuit CU.

Specifically, for example, when the p-channel-type MOSFET QH is in an on-state and the n-channel-type MOSFET QL is in an off-state, the output terminal HVO becomes the same electric potential as the power source electric potential VH. On the other hand, when the p-channel-type MOSFET QH is in an off-state and the n-channel-type MOSFET QL is in an on-state, the output terminal HVO becomes the same electric potential as the reference electric potential GND. Furthermore, when both the p-channel-type MOSFET QH and the n-channel-type MOSFET QL are in the off-state, the output terminal HVO becomes a high impedance state. In this manner, the output voltage from the output terminal HVO can be controlled by controlling the switching operation of the p-channel-type MOSFET QH and the n-channel-type MOSFET QL by the output-stage control circuit CU.

FIG. 25 is a drawing showing a configuration of the case in which the channel of the output-stage circuit OC shown in FIG. 24 is multiplied. Specifically, FIG. 25 shows a circuit in which the number of channels is n. Each of the output-stage circuits OC(1) to OC (n) having multiplied channels in this manner is provided with a plurality of output terminals HVO(1) to HVO(n). In the output-stage circuits OC(1) to OC (n) having the multiplied channels, as the multiplication of the channels is advanced, as the density of the output current per one channel is reduced, and as the power source electric potential VH is increased, the element area of the p-channel-type MOSFET QH and the n-channel-type MOSFET QL in an integrated circuit is increased.

However, in the present invention, as described in the above-described first embodiment, the density of the output current per a single medium/high-voltage MOSFET (p-channel-type MOSFET QH and n-channel-type MOSFET QL) can be improved; therefore, multiplication of the channels for ensuring the same output current in total can be minimized. This means that the size of the output-stage circuit OC can be reduced according to the present invention, and the cost of the integrated circuit can be therefore reduced according to the present invention.

In the foregoing, the invention made by the inventors of the present invention has been concretely described based on the embodiments. However, it is needless to say that the present invention is not limited to the foregoing embodiments and various modifications and alternations can be made within the scope of the present invention.

In the above-described first to third embodiments, the examples in which the technical ideas of the present invention are applied to the medium/high-voltage MOSFETs have been described. However, the present invention is not limited thereto, and the technical ideas of the present invention can be applied also to, for example, IGBTs (Isolated Gate Bipolar Transistors). More specifically, if the drain region DR which is the n-type semiconductor region shown in FIG. 1 is replaced by a p-type semiconductor region, an IGBT is obtained. The IGBT also have problems similar to those of medium/high-voltage MOSFETs regarding stabilization of the threshold voltage and reduction in the on-state resistance (channel resistance); therefore, it is very effective to apply the technical ideas of the present invention to the IGBT. In the present specification, it is considered that IGBTs are included in the general ideas of field-effect transistors as a type of field-effect transistors.

In the above-described first to second embodiments, the n-channel-type MOSFETs have been described. However, the present invention is not limited thereto, and the technical ideas of the present invention can be applied also to p-channel-type MOSFETs. Specifically, the application can be carried out by replacing the n-type semiconductor region of the n-channel-type MOSFET by a p-type semiconductor region and replacing the p-type semiconductor region of the n-channel-type MOSFET by an n-type semiconductor region.

Furthermore, since the technical ideas of the present invention are about the source region and the channel region, upon application, the technical ideas can be applied to wide variety of structures without depending on the disposition of the drain region. More specifically, in the above-described first to second embodiments, what is called horizontal-type MOSFETs (planar type MOSFETs) in which the source region and the drain region are formed in the same surface side of the semiconductor substrate have been described. However, for example, the technical ideas of the present invention can be also applied to so-called vertical type MOSFETs in which the drain region is formed in the back surface in the opposite side of the surface in which the source region is formed.

The present invention can be widely utilized in the manufacturing industry that manufactures and utilizes semiconductor devices.

## Claims

1. A semiconductor device comprising a field-effect transistor, the field-effect transistor having:
(a) a semiconductor substrate (1S) of a first conductivity type;
(b) a body region (BD) of a second conductivity type formed in the semiconductor substrate (1S);
(c) a source region (SR) of the first conductivity type formed in a surface of the semiconductor substrate (1S) so as to be included in the body region (BD) in a planar view;
(d) a channel region (CH) of the second conductivity type adjacent to the source region (SR) and formed in the surface of the semiconductor substrate (1S) so as to be included in the body region (BD) in the planar view;
(e) a first semiconductor region (NR1) of the first conductivity type adjacent to the channel region (CH), formed in the surface of the semiconductor substrate (1S) so as to be included in the body region (BD) in the planar view, and electrically connected to the semiconductor substrate (1S);
(f) a gate insulating film (GOX) formed at least on the channel region (CH) and the first semiconductor region (NR1); and
(g) a gate electrode (G) formed on the gate insulating film (GOX),
wherein the width (L) of the channel region (CH) sandwiched by the source region (SR) and the first semiconductor region (NR1) in a horizontal direction parallel to the surface of the semiconductor substrate (1S) is larger than or equal to 1/5 times the thickness (t) of the gate electrode (G) and smaller than or equal to the thickness (t) of the gate electrode (G); and,
when the body region (BD) is divided into an upper-layer body region and a lower-layer body region, an end of the lower-layer body region is projecting to the outside more than an end of the upper-layer body region.

2. The semiconductor device according at least one of claims 1 and 10 to 15, wherein
the impurity concentration of the first semiconductor region (NR1) is higher than the impurity concentration of the semiconductor substrate (1S).

3. The semiconductor device according to at least one of claims 1, 2 and 10 to 15, wherein,
in a stacking direction perpendicular to the surface of the semiconductor substrate (1S), the first semiconductor region (NR1) is structured to be sandwiched by the body region (BD) and the gate electrode (G) via the gate insulating film (GOX).

4. A semiconductor device comprising a field-effect transistor, the field-effect transistor having:
(a) a semiconductor substrate (1S) of a first conductivity type;
(b) a body region (BD) of a second conductivity type formed in the semiconductor substrate (1S);
(c) a source region (SR) of the first conductivity type formed in a surface of the semiconductor substrate (1S) so as to be included in the body region (BD) in a planar view;
(d) a channel region (CH) of the second conductivity type adjacent to the source region (SR) and formed in the surface of the semiconductor substrate (1S) so as to be included in the body region (BD) in the planar view;
(e) a first semiconductor region (NR1) of the first conductivity type adjacent to the channel region (CH), formed in the surface of the semiconductor substrate (1S) so as to be included in the body region (BD) in the planar view, and electrically connected to the semiconductor substrate (1S);
(f) a gate insulating film (GOX) formed at least on the channel region (CH) and the first semiconductor region (NR1); and
(g) a gate electrode (G) formed on the gate insulating film (GOX),
wherein the width (L) of the channel region (CH) sandwiched by the source region (SR) and the first semiconductor region (NR1) in a horizontal direction parallel to the surface of the semiconductor substrate (1S) is larger than or equal to 100 nm and smaller than or equal to 500 nm; and,
when the body region (BD) is divided into an upper-layer body region and a lower-layer body region, an end of the lower-layer body region is projecting to the outside more than an end of the upper-layer body region.

5. The semiconductor device according to claim 4, wherein
the impurity concentration of the first semiconductor region (NR1) is higher than the impurity concentration of the semiconductor substrate (1S).

6. A semiconductor device comprising a field-effect transistor, the field-effect transistor having:
(a) a semiconductor substrate (1S) of a first conductivity type;
(b) a body region (BD) of a second conductivity type formed in the semiconductor substrate (1S);
(c) a source region (SR) of the first conductivity type formed in a surface of the semiconductor substrate (1S) so as to be included in the body region (BD) in a planar view;
(d) a channel region (CH) of the second conductivity type adjacent to the source region (SR) and formed in the surface of the semiconductor substrate (1S) so as to be included in the body region (BD) in the planar view;
(e) a gate insulating film (GOX) formed at least on the channel region (CH); and
(f) a gate electrode (G) formed on the gate insulating film (G),
wherein the width (L) of the channel region (CH) sandwiched by the source region (SR) and the body region (BD) in a horizontal direction parallel to the surface of the semiconductor substrate (1S) is larger than or equal to 1/5 times the thickness (t) of the gate electrode (G) and smaller than or equal to the thickness (t) of the gate electrode (G); and,
when the body region (BD) is divided into an upper-layer body region and a lower-layer body region, an end of the lower-layer body region is projecting to the outside more than an end of the upper-layer body region.

7. The semiconductor device according to at least one of claims 1 to 6 and 10 to 15, wherein
the impurity concentration of the channel region (CH) is higher than the impurity concentration of the body region (BD).

8. A semiconductor device comprising a field-effect transistor, the field-effect transistor having:
(a) a semiconductor substrate (1S) of a first conductivity type;
(b) a body region (BD) of a second conductivity type formed in the semiconductor substrate (1S);
(c) a source region (SR) of the first conductivity type formed in a surface of the semiconductor substrate (1S) so as to be included in the body region (BD) in a planar view;
(d) a channel region (CH) of the second conductivity type adjacent to the source region (SR) and formed in the surface of the semiconductor substrate (1S) so as to be included in the body region (BD) in the planar view;
(e) a gate insulating film (GOX) formed at least on the channel region (CH); and
(f) a gate electrode (G) formed on the gate insulating film (GOX),
wherein the width (L) of the channel region (CH) sandwiched by the source region (SR) and the body region (BD) in a horizontal direction parallel to the surface of the semiconductor substrate (1S) is larger than or equal to 100 nm and smaller than or equal to 500 nm; and,
when the body region (1S) is divided into an upper-layer body region and a lower-layer body region, an end of the lower-layer body region is projecting to the outside more than an end of the upper-layer body region.

9. The semiconductor device according to claim 8, wherein
the impurity concentration of the channel region (CH) is higher than the impurity concentration of the body region (BD).

10. A semiconductor device comprising a field-effect transistor, the field-effect transistor having:
(a) a semiconductor substrate (1S) of a first conductivity type;
(b) a body region (BD) of a second conductivity type formed in the semiconductor substrate (1S);
(c) a source region (SR) of the first conductivity type formed in a surface of the semiconductor substrate (1S) so as to be included in the body region (BD) in a planar view;
(d) a channel region (CH) of the second conductivity type adjacent to the source region (SR) and formed in the surface of the semiconductor substrate (1S) so as to be included in the body region (BD) in the planar view;
(e) a gate insulating film (GOX) formed at least on the channel region (CH); and
(f) a gate electrode (G) formed on the gate insulating film (GOX),
wherein the width (L) of the channel region (CH) sandwiched by the source region (SR) and the body region (BD) and/or a first semiconductor region (NR1) of the first conductivity type adjacent to the channel region (CH) in a horizontal direction parallel to the surface of the semiconductor substrate (1S) is larger than or equal to 1/5 of a predetermined value and smaller than or equal to the predetermined value; and,
when the body region (BD) is divided into an upper-layer body region and a lower-layer body region, an end of the lower-layer body region is projecting to the outside more than an end of the upper-layer body region.

11. The semiconductor device according to claim 10, wherein the predetermined value is chosen according to the thickness (t) of the gate electrode (G) so that the width (L) of the channel region (CH) sandwiched by the source region (SR) and the body region (BD) in a horizontal direction parallel to the surface of the semiconductor substrate (1S) is larger than or equal to 1/5 times the thickness (t) of the gate electrode (G) and smaller than or equal to the thickness (t) of the gate electrode (G).

12. The semiconductor device according to claim 10 or 11, wherein
the predetermined value is 500nm so that the width of the channel region (VH) sandwiched by the source region (SR) and the body region (BD) in a horizontal direction parallel to the surface of the semiconductor substrate (1S) is larger than or equal to 100 nm and smaller than or equal to 500 nm.

13. The semiconductor device according to claim 10, wherein
the field-effect transistor further has the first semiconductor region (NR1) of the first conductivity type adjacent to the channel region (CH), formed in the surface of the semiconductor substrate (1S) so as to be included in the body region (BD) in the planar view, and electrically connected to the semiconductor substrate (1S);
wherein the gate insulating film (GOX) is formed at least on the channel region (CH) and the first semiconductor region (NR1); and
the width (L) of the channel region (CH) sandwiched by the source region (SR) and the first semiconductor region (NR1) in a horizontal direction parallel to the surface of the semiconductor substrate (1S) is larger than or equal to 1/5 of the predetermined value and smaller than or equal to the predetermined value.

14. The semiconductor device according to claim 13, wherein the predetermined value is chosen according to the thickness (t) of the gate electrode (G) so that the width (L) of the channel region (CH) sandwiched by the source region (SR) and the first semiconductor region (NR1) in a horizontal direction parallel to the surface of the semiconductor substrate (1S) is larger than or equal to 1/5 times the thickness (t) of the gate electrode (G) and smaller than or equal to the thickness (t) of the gate electrode (G).

15. The semiconductor device according to claim 13 or 14, wherein
the predetermined value is 500nm so that the width (L) of the channel region (CH) sandwiched by the source region (SR) and the first semiconductor region (NR1) in a horizontal direction parallel to the surface of the semiconductor substrate (1S) is larger than or equal to 100 nm and smaller than or equal to 500 nm.
